(19) Europäisches Patentamt
European Patent Office
Office européen des brevets

(11) **EP 1 975 979 B1**

(12) **EUROPEAN PATENT SPECIFICATION**

(45) Date of publication and mention
of the grant of the patent:
**15.08.2012 Bulletin 2012/33**

(51) Int Cl.:
*H01L 21/00* (2006.01)     *B05C 11/06* (2006.01)
*G03F 7/16* (2006.01)

(21) Application number: **06834803.6**

(22) Date of filing: **15.12.2006**

(86) International application number:
**PCT/JP2006/325060**

(87) International publication number:
**WO 2007/069728 (21.06.2007 Gazette 2007/25)**

(54) **COATING APPARATUS AND COATING METHOD**

BESCHICHTUNGSVORRICHTUNG UND BESCHICHTUNGSVERFAHREN

DISPOSITIF ET PROCEDE DE REVETEMENT

(84) Designated Contracting States:
**DE FR IT NL**

(30) Priority: **15.12.2005 JP 2005362076**
**28.04.2006 JP 2006126802**

(43) Date of publication of application:
**01.10.2008 Bulletin 2008/40**

(73) Proprietor: **TOKYO ELECTRON LIMITED**
**Minato-ku**
**Tokyo 107-8481 (JP)**

(72) Inventors:
• **SAWADA, Ikuo**
**Nirasaki-shi**
**Yamanashi 407-0192 (JP)**
• **MATSUZAKI, Kazuyoshi**
**Nirasaki-shi**
**Yamanashi 407-0192 (JP)**
• **TANAKA, Takashi**
**Nirasaki-shi**
**Yamanashi 407-0192 (JP)**
• **IWASHITA, Mitsuaki**
**Nirasaki-shi**
**Yamanashi 407-0192 (JP)**
• **MUNAKATA, Mizue**
**Kumamoto-shi**
**Kumamoto 860-8555 (JP)**

(74) Representative: **HOFFMANN EITLE**
**Patent- und Rechtsanwälte**
**Arabellastrasse 4**
**81925 München (DE)**

(56) References cited:
JP-A- 3 245 870        JP-A- 05 166 712
JP-A- 2002 118 051    JP-A- 2004 128 214
JP-A- 2005 000 726    JP-A- 2005 093 794
US-A1- 2002 041 935

## Description

Field of the Invention

This invention relates to a coating apparatus and a coating method of coating a substrate with a chemical such as a resist.

Background Art

Conventionally, as a technique of coating a substrate such as a semiconductor wafer (hereinafter, wafer), a glass substrate for a liquid crystal display and a substrate for a color filter, with a chemical, a spin coating method has been widely used in order to make substantially uniform the thickness of a coated film and to make thinner the same.

Given herein as an example to describe the spin coating method is a case where a resist liquid is applied to a wafer. At first, in a chamber including a spin chuck on which a wafer can be placed, air is supplied from an upper part of the chamber, and the air is discharged from a lower part of the chamber. Thus, a down flow of air for preventing scattering of particles is formed in the chamber. Following thereto, a wafer is placed on the spin chuck, and the wafer is horizontally held. Thereafter, a resist liquid is supplied to a central portion of the wafer, from a nozzle disposed above the wafer, while the wafer is being rotated via the spin chuck at about 2000 rpm about the vertical axis.

The resist liquid that has been supplied onto the wafer is spread out by a centrifugal force from the central portion of the wafer W to a circumferential portion thereof. Then, by reducing the rotational speed of the wafer to, e.g., 100 rpm, the spread-out resist liquid is leveled. After this leveling, the rotational speed of the wafer is increased to, e.g., about 2500 rpm, so that the excessive resist liquid on the wafer is spun off and removed. In addition, since a solvent contained in the resist liquid on the wafer is exposed to an airflow which is generated on the wafer by the rotation of the same, almost all of the solvent is evaporated within about 10 seconds from the time when the rotational speed was increased after the leveling. After the solvent was evaporated, the wafer is continuously rotated for a while, e.g., for about 1 minute from the time when the resist liquid was supplied. Thus, the resist liquid is dried, and a resist film is formed on the wafer.

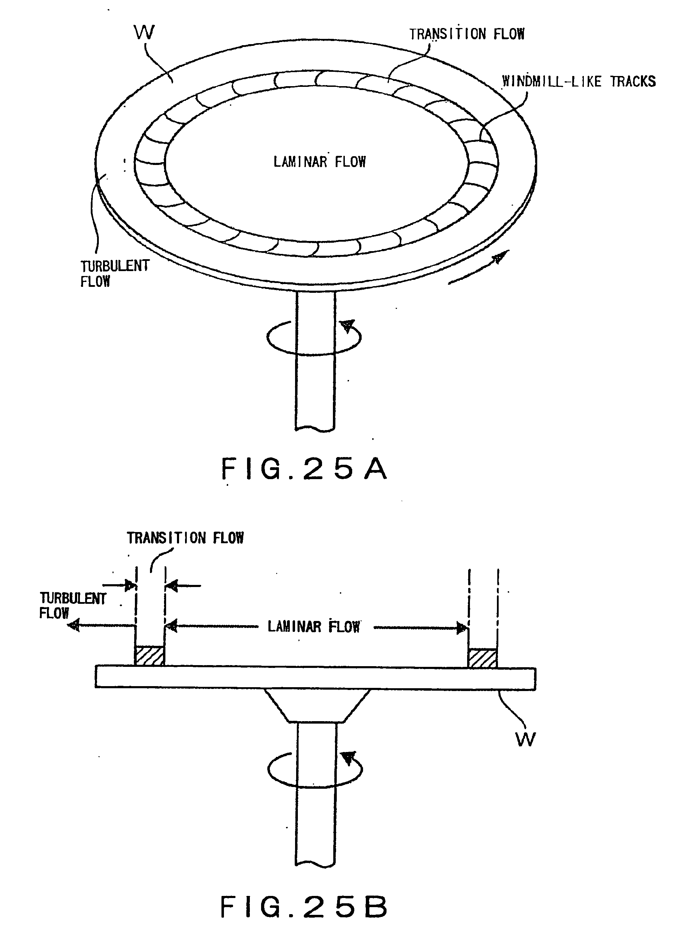

Recently, there has been technical demand for improving such a coating method. In particular, further reduction in thickness of the coated film and reduction in time period required for the coating process have been desired. In the aforementioned spin coating method, in order to achieve the reduction in thickness of the coated film and also the reduction in the process period, it can be considered to increase the rotational speed of the substrate. However, when a resist liquid is applied to a large wafer, such as a 12-inch wafer, an increase in the rotational speed of the wafer may invite, as shown in Fig. 25A, formation of about 30 wrinkles on a surface of the coated resist in an area close to the peripheral edge of the wafer, which makes non-uniform the film thickness.

These wrinkles are called "windmill-like tracks". The "windmill-like tracks" are generated because non-uniformity of airflow-speed in the circumferential direction of the substrate, which is caused at an area where a speed-boundary layer of the air on the substrate changes from a laminar flow to a transition flow, is transferred to the resist-film thickness through an evaporation step. This airflow-speed non-uniformity is a scientifically famous phenomenon called "Ekman spin". This phenomenon, which is described in detail in J. Appl. Phys. 77(6), 15(1995), pp. 2297-2308, is a natural phenomenon that appears when the Re (Reynolds) number of a rotating substrate exceeds a certain value. The Re number is calculated by the following expression (1) in which a distance from the center of the substrate is r (mm), an angular speed of the substrate is $\omega$ (rad/s), and a coefficient of kinematic viscosity of a gas around the substrate is v (mm$^2$/s).

$$\text{Re number} = r\omega^2 \, / \, v \, \cdots \, (1)$$

On the surface of a wafer which is being rotated, for example, a laminar flow is formed at an area where the Re number < 80000, a transition flow is formed at an area where 80000 < Re number < 3 × 10$^5$, and a turbulent flow is generated at an area where the Re number > 3 × 10$^5$.

As shown in the expression (1), the Re number increases in proportion to r. Thus, as shown in Figs. 25A and 25B, when a wafer of a predetermined size is rotated at a predetermined speed, there appears an area on which the laminar flow is formed, the area being extended as far as a position radially distant from the center of the wafer by a predetermined distance, which is determined by the rotational speed of the wafer. On the outside of the laminar flow, there appears an area on which the turbulent flow is generated. On the boundary between these areas, there appears an area on which a transition flow changing from the laminar flow to the turbulent flow is formed. As has been described above, at the step in which almost all of the solvent contained in the resist liquid is evaporated, when the resist liquid is exposed to the transition flow whose speed is non-uniform, the solvent on a part exposed to an airflow of a higher flow speed is more quickly evaporated than the solvent on a part exposed to an airflow of a lower flow speed. Accordingly, the non-uniform flow of the airflow(s) is transferred to the resist film. As a result, the film-thickness of the resist is made non-uniform, and the windmill-like tracks are formed in the circumferential direction of the wafer.

When the resist liquid is exposed to the turbulent flow at the step in which the solvent is evaporated, the solvent on the surface of the resist liquid is evaporated too fast. In this case, there is formed a so-called "crust-like structure" in which a thin film of a polymer of the resist liquid is formed on the surface of the coated resist film, with the solvent remaining below the thin film. In this case, there is a possibility that the thickness of the overall structure is larger than the thickness of the area on which the laminar flow is formed.

In view of the above, the Re number has to be decreased in order to widen an area on which the resist film can have the uniform thickness.

On the other hand, the value of a coefficient of kinematic viscosity of a gas can be calculated from the following expression (2). In the expression (2), $\mu$ represents a coefficient of viscosity (Pa·s) of a gas around a wafer, and p represents a density (kg/m$^3$) of the gas

$$\nu = \mu / \rho \ldots (2)$$

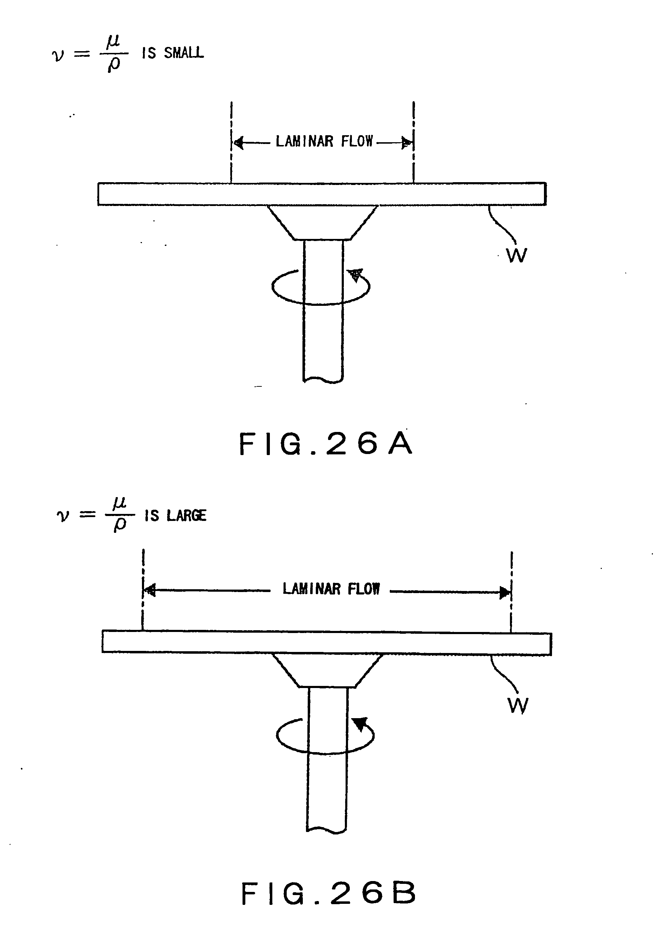

In the expression (1), when the angular speed of the wafer is kept constant, the radius of the laminar flow, i.e., the value of the r in the expression (1) when the Re number takes 80000, is decreased by decreasing the value of the v. Namely, as shown in Fig. 26A, the area on which the laminar flow is formed is narrowed. On the other hand, by increasing the value of the v, the value of the r in the expression (1) when the Re number takes 80000 is also increased. Namely, as shown in Fig. 26B, the area on which the laminar flow is formed is widened, so that a position at which the transition flow starts to be generated comes nearer to the peripheral edge of the wafer.

Thus, in order to widen the area on which the thickness of the resist film can be made uniform, the value of the gas coefficient of kinematic viscosity is preferably increased. In order to increase the value of the v, it is preferable to use a gas of a lower value of the density p, which is understandable from the expression (2).

When the spin coating method is performed, with a view to preventing scattering of the coating liquid, a cup having an opened upper part is generally located around a substrate placed on a spin chuck. JP5-283331A discloses a coating apparatus adapted to perform a rotational coating in which the upper part of such a cup is covered with a lid, and an air in the space surrounded by the cup and the lid is replaced with an He (helium) gas. As another coating apparatus, JP5-283331A and JP61-150126A respectively disclose a coating apparatus adapted to perform a rotational coating in which there is disposed a lid at a position several millimeters above a substrate placed on a spin chuck, such that the lid is opposed to the substrate so as to cover the overall surface of the substrate, and an air in the space between the substrate and the lid is replaced with a gas such as an He gas or the like whose density is lower than that of the air. With the use of the coating apparatuses described in these publications to replace the air around the substrate with an He gas, the value of the v can be increased as much as about 9 times.

In addition, JP3-245870A discloses a coating apparatus adapted to perform a rotational coating in which a down flow of a mixed gas formed of an He gas and an air is formed in a chamber in which a spin chuck is installed, so that an air in the chamber is replaced with the mixed gas.

However, in the coating apparatus described in JP5-283331A in which the air in the space surrounded by the lid and the cup is replaced with an He gas, a time lag may occur between a time point at which the supply of the He gas is started and a time point at which a sufficient amount of the He gas is stored so as to lower the gas density in the space surrounded by the lid and the cup.

In addition, in order to rapidly discharge a mist-like coating liquid that has been scattered with the rotation of the substrate, the general rotational coating apparatus is equipped, in the vicinity of a rotating substrate, with a gas-discharging mechanism capable of discharging the gas (mist) at a volume of displacement (exhaustion) not less than 1 m$^3$/min.

Thus, when a coating process is performed by the rotational coating apparatus described in JP5-283331A, it is necessary, before the coating process, to replace an atmosphere in the space surrounded by the cup and the lid with an He gas, and further it is necessary to continue the supply of the He gas at a flow rate corresponding to the volume of displacement during the coating process. That is, a required amount of the He gas throughout the coating process is increased, which results in increase in cost.

With respect also to the coating apparatus described in JP3-245870A, it is necessary to supply the mixed gas containing an He gas into the whole chamber. Thus, similar to the coating apparatus described in JP5-283331A, a time lag may occur before the mixed gas is fully supplied, and thus an increasing amount of the He gas to be used may increase the cost.

As described in JP5-283331A and JP61-150126A, when the lid that covers the overall surface of the rotating substrate is provided, there is a possibility that the coating liquid that has been scattered and made misty by the rotation of the substrate adheres to the lid and becomes particles, and that the particles fall therefrom and adhere onto the substrate. In order to remove such adherend of the lid, so as to prevent the adhesion of the particles to the substrate, the lid has to be washed. However, such a washing process requires additional cost. Moreover, since the lid covers the overall surface of the substrate, the aforementioned down flow cannot be formed around the substrate. Thus, there still remains a possibility that particles are scattered around the substrate.

US 2002/0041935 A1 relates to a coating unit comprising:

a spin chuck that holds a wafer horizontally, a resist solution supply nozzle that supplies a resist solution to a central portion of the wafer horizontally held by the spin chuck; and a spinning mechanism that causes the spin chuck to rotate in order to spread out the resist resolution on a surface of the wafer by a centrifugal force, for coating the whole surface with the resist solution, a number of ventilation holes that are capable of forming a downflow of an atmospheric gas on the surface of the wafer horizontally held by the spin chuck, an exhaust part that is capable of discharging an atmosphere on the wafer, and wherein the atmospheric gas of the laminate flow forming gas is supplied to a central portion of the wafer.

Summary of the Invention

In view of the aforementioned problems and in order to solve them effectively, we accomplished the present invention. Accordingly, an object of the present invention is to provide a coating apparatus and a coating method wherein generation of windmill-like tracks is effectively inhibited by enlarging an area in which a laminar flow is formed, when a spin coating with a chemical is conducted to a substrate.

The coating apparatus of the present invention is a coating apparatus comprising: a substrate-holding part that is arranged to hold a substrate horizontally; a chemical nozzle that is arranged to supply a chemical to a central portion of the substrate horizontally held by the substrate-holding part; a rotation mechanism that is arranged to cause the substrate-holding part to rotate in order to spread out the chemical on a surface of the substrate by a centrifugal force, for coating the whole surface with the chemical; a gas-flow-forming unit that is arranged to form a down flow of an atmospheric gas on the surface of the substrate horizontally held by the substrate-holding part; a gas-discharging unit that is arranged to discharge an atmosphere around the substrate; and a gas nozzle that is arranged to supply a laminar-flow-forming gas to the surface of the substrate, the laminar-flow-forming gas having a coefficient of kinematic viscosity larger than that of the atmospheric gas; wherein the apparatus is arranged to supply the atmospheric gas or the laminar-flow-forming gas to the central portion of the substrate.

Herein, to supply the laminar-flow-forming gas to the surface of the substrate is not limited to the supply of the gas to the substrate from vertical directions, but includes the supply of the gas from diagonal directions, and further includes the supply of the gas from horizontal directions along the surface of the substrate.

According to embodiments of the above invention, when the surface of the substrate, which has been spin-coated with the chemical, is spin-dried, while forming the down flow of the atmospheric gas, by supplying the laminar-flow-forming gas having a coefficient of kinematic viscosity larger than that of the atmospheric gas, the laminar-flow-forming gas is mixed into the gas flow of the atmospheric gas spreading outward along the surface of the substrate. Thus, the coefficient of kinematic viscosity of the gas flow formed on the surface of the substrate is increased. Since a radius of a laminar flow to be formed on the surface of the substrate is in proportion to the coefficient of kinematic viscosity of the gas, a laminar-flow area on the surface of the substrate is widened. Thus, generation of windmill-like tracks on the surface of the substrate can be restrained to thereby perform an improved coating process.

In addition, since the supply of the laminar-flow-forming gas to the surface of the substrate is performed by the nozzle, the consumption of the 1 aminar-flow-forming gas can be reduced, as compared with an art for replacing the whole atmosphere, in which the substrate is placed, with the laminar-flow-forming gas, and thus a long time period for replacing the gas can be saved. In addition, since the substrate is located in the down flow of the atmosphere, and the atmosphere is discharged from around the substrate, there can be eliminated the problem associated with a method in which a lid is provided above the substrate to form a closed space. Namely, there is no possibility that mist scattered form the substrate adheres to the lid and becomes particles.

In embodiments of the present invention, for example, the gas nozzle has a gas ejecting part that opens in a radial direction of the substrate from a position above the central portion of the substrate. Alternatively, the gas nozzle has a gas ejecting part consisting of a large number of holes arranged in a radial direction of the substrate from a position above the central portion of the substrate.

Preferably, the gas nozzle has a porous body. In addition, preferably, a flow rate ejected from the gas nozzle is larger at an area closer to a peripheral edge of the substrate. For example, preferably, depending on the position, by a distance thereof from the central portion of the substrate in the direction toward the peripheral portion thereof, the flow rate of the gas being ejected from the gas nozzle is larger in a stepwise or continuous manner.

In addition, for example, the gas nozzle can be configured to supply the laminar-flow-forming gas both to the central portion of the substrate and to an area of the substrate apart from the central portion thereof. Alternatively, the gas nozzle is configured to supply the laminar-flow-forming gas to an area of the substrate apart from the central portion thereof, and the central portion of the substrate is adapted to be exposed to the down flow of the atmospheric gas.

In addition, for example, a second gas nozzle is provided independently from the gas nozzle, the second gas nozzle being configured to supply a laminar-flow-forming gas or the atmospheric gas to the central portion of the substrate.

Alternatively, the coating method of the present invention is a coating method of coating a substrate with a chemical, the coating method comprising: a step of causing a substrate-holding part to hold a substrate horizontally; a step of discharging an atmosphere around the substrate while forming a down flow of an atmospheric gas on a surface of the substrate held by the substrate-holding part; a coating step, by supplying a chemical from a chemical nozzle to a central portion of the substrate, causing the substrate-holding part to rotate, and thus spreading out the chemical on the surface of the substrate by a centrifugal force for coating the whole surface with the chemical; and a drying step, by supplying a laminar-flow-forming gas from a gas nozzle to the surface of the substrate under a state wherein the substrate is caused to rotate, and supplying the atmospheric gas or the laminar-flow-forming gas to the central portion of the substrate, so as to dry the chemical, after the coating step, the laminar-flow-forming gas having a coefficient of kinematic viscosity larger than that of the atmospheric gas.

In this method, a timing at which the laminar-flow-forming gas is supplied to the surface of the substrate and the atmospheric gas or the laminar-flow-forming gas are supplied to the central portion of the substrate is, for example, the same as or prior to a timing at which the substrate starts to rotate with a rotation number suitable for drying the chemical.

Brief Description of the Drawings

In the following, reference will now be made to the enclosed drawings, by way of example only, in which:

Fig. 1A is a vertical sectional view showing a coating apparatus according to an embodiment of the present invention;

Fig. 1B is a transversal sectional view of the coating apparatus shown in Fig. 1A;

Fig. 2 is a perspective view showing structures of nozzles of the coating apparatus shown in Fig. 1A;

Fig. 3A is a front view showing an example of a structure of a gas nozzle for ejecting a helium gas of the coating apparatus shown in Fig. 1A;

Fig. 3B is a cross-sectional view showing the structure of the gas nozzle shown in Fig. 3A;

Fig. 4 is a vertical sectional view showing an example of a structure of a side peripheral wall of the gas nozzle shown in Fig. 3A;

Figs. 5A to 5D are flowcharts showing a process of coating a wafer with a resist, which is performed by the coating apparatus shown in Fig. 1A;

Fig. 6A is a longitudinal front view showing a gas ejecting process with an inclination of the gas nozzle being changed;

Fig. 6B is a plan view showing the gas ejecting process with the inclination of the gas nozzle being changed;

Fig. 7A is a front view showing another example of a structure of the gas nozzle for ejecting a helium gas;

Fig. 7B is a bottom view showing the structure of the gas nozzle shown in Fig. 7A;

Figs. 8A and 8B are perspective views showing a gas ejecting process to a wafer, by using the gas nozzle shown in Fig. 7A;

Fig. 9A is a front view showing another example of a structure of the gas nozzle for ejecting a helium gas;

Fig. 9B is a bottom view showing the structure of the gas nozzle shown in Fig. 9A;

Fig. 10A is a perspective view showing a gas ejecting process to a wafer, by using the gas nozzle shown in Fig. 9A;

Fig. 10B is a plan view showing the gas ejecting process to a wafer, by using the gas nozzle shown in Fig. 9A;

Fig. 11A is a front view showing another example of a structure of the gas nozzle for ejecting a helium gas;

Fig. 11B is a transversal sectional view showing the structure of the gas nozzle shown in Fig. 11A;

Fig. 11C is a perspective view showing a gas ejecting process to a wafer, by using the gas nozzle shown in Fig. 11A;

Fig. 12A is a front view showing another example of a structure of the gas nozzle for ejecting a helium gas;

Fig. 12B is a bottom view showing the structure of the gas nozzle shown in Fig. 12A;

Fig. 13A is a perspective view showing a gas ejecting process to a wafer, by using a gas nozzle of another structure;

Fig. 13B is a sectional view showing a main part of Fig. 13A;

Fig. 14A is a perspective view of a gas ejecting process to a wafer, by using a gas nozzle of another structure;

Fig. 14B is a perspective view of a gas ejecting process to a wafer, by using the gas nozzle of another structure;

Figs. 15A and 15B are a view and a table for explaining a condition of an oil film which is formed on a wafer, with an angle and a height of the gas nozzle with respect to a wafer being changed;

Figs. 16A to 16D are views for explaining gas ejecting processes to respective wafers by using gas nozzles of different structures;

Figs. 17A and 17B are views for explaining gas ejecting processes to respective wafers by using gas nozzles of different structures;

Figs. 18A to 18C are perspective views showing conditions of surfaces of respective wafers;

Fig. 19 is a graph showing a relationship between a rotational speed of a wafer, timings at which respective steps are started, and a timing at which a helium gas is ejected;

Fig. 20 is a table showing a relationship between a rotational speed of a wafer and a condition of a surface of the wafer, at a drying step;

Figs. 21A and 21B are schematic views showing a structure of the gas nozzle used in an example;

Figs. 22A to 22C are views for explaining gas ejecting processes to wafers from respective gas nozzles in examples;

Fig. 23 is a table showing a relationship between a rotational speed of a wafer and a condition of a surface of the wafer, at a drying step;

Fig. 24 is a graph showing a relationship between a distance from a center of a wafer and a film-thickness of a resist on a surface of the wafer;

Figs. 25A and 25B are views for explaining formation of a transition flow on a wafer W; and

Figs. 26A and 26B are views for explaining a change of an area at which a laminar flow is formed, with a coefficient of kinematic viscosity of a gas around a wafer being changed.

Description of the Preferred Embodiment

As an embodiment of the present invention, a coating apparatus 2 which coats a wafer W as a substrate with a resist (liquid) as a chemical (liquid) is explained.

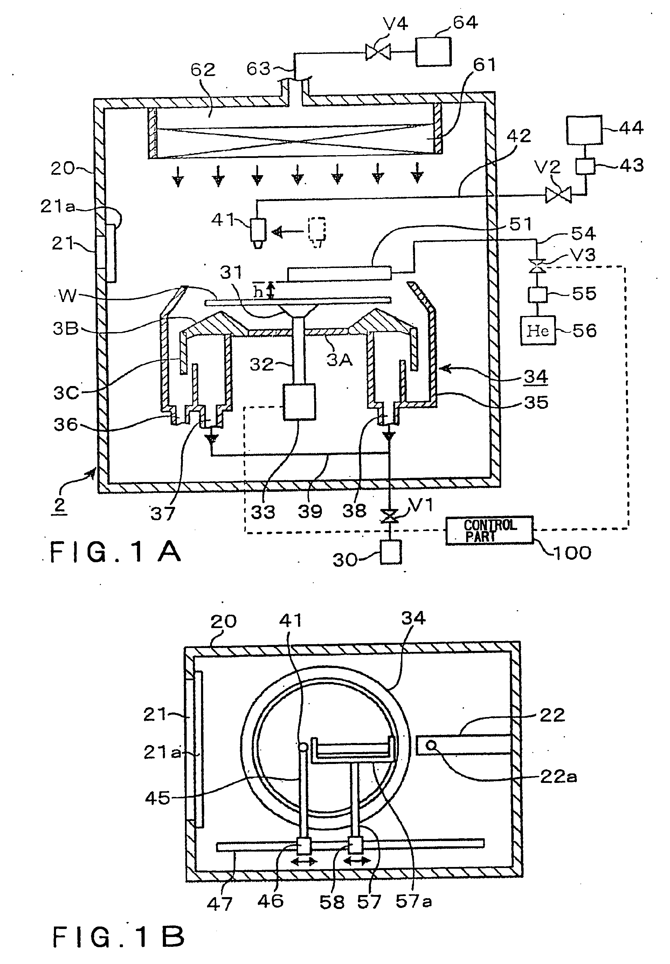

Figs. 1A and 1B are a vertical sectional view and a transversal sectional view of the coating apparatus 2 in this embodiment. In Figs. 1A and 1B, the reference number 20 depicts a housing. The reference number 21 is a transfer port for a wafer W, which is formed to face a transfer channel through which a wafer W is transferred by a transfer mechanism, not shown, for example. The reference number 21a depicts an openable and closable shutter disposed on the transfer port 21. The shutter 21a is configured such that the shutter 21a is closed excluding a case in which a wafer W is loaded into the housing 20 by the transfer mechanism, and a case in which a wafer W is unloaded from the housing 20 by the transfer mechanism. Thus, flowing of a gas from the transfer channel into the housing 20 can be restrained.

The reference number 31 depicts a spin chuck as a substrate holder, disposed in the housing 20. The spin chuck 31 is capable of sucking and absorbing a central portion of a rear surface of a wafer W so as to hold the wafer W horizontally. The spin chuck 31 is connected to a drive part 33 through a shaft part 32. With holding a wafer W, the spin chuck 31 can be rotated about a vertical axis and can be moved upward and downward, through the drive part 33.

The reference number 34 depicts a cup having an upper opening, which is disposed on an outside of a peripheral edge of a wafer W held by the spin chuck 31 to surround the wafer W. An upper part of a side peripheral wall of the cup 34 is inclined inward. On a bottom side of the cup 34, a liquid-receiving part 35 of a recessed shape is disposed below the peripheral edge of the wafer W to cover all the circumference of the wafer W. The liquid-receiving part 35 is divided into an outside area and an inside area. Formed in a bottom part of the outside area is a drain port 36 for discharging a stored resist.

Two gas-discharging ports 37 and 38 are formed in a bottom part of the inside area. Ends on a branched side of a gas-discharging pipe 39 are connected to each of the gas-discharging ports 37 and 38. The other end on a merged side of the gas-discharging pipe 39 is connected to a gas-discharging unit 30, such as an air displacement pump, via a valve V1. Thus, by adjusting an opening degree of the valve V1, for example, a gas in the cup 34 can be discharged at a volume of displacement between 1 $m^3$/min and 3 $m^3$/min. When the gas is discharged by opening the valve V1, an He gas which has been ejected onto the wafer W and an air which has been supplied around the wafer W flow into the gas-discharging pipe 39 via the gas-discharging ports 37 and 38 so as to be removed from the housing 20, which is described below. In addition, along with the thus formed discharged-gas current, a mist-like resist, which has been scattered by the rotation of the wafer W, can be discharged from the drain port 36 through the liquid-receiving part 35.

A circular plate 3A is located below the wafer W held by the spin chuck 31. Further, a ring member 3B having a chevron cross-section is provided so as to surround an outside of the circular plate 3A. Furthermore, disposed on an outer edge of the ring member 3B is an end plate 3C which is extended below to enter the outside area of the liquid-receiving part 35. Thus, a resist falling from the wafer W can be moved along the surfaces of the ring member 3B and the end plate 3C so as to be guided into the outside area of the liquid-receiving part 35.

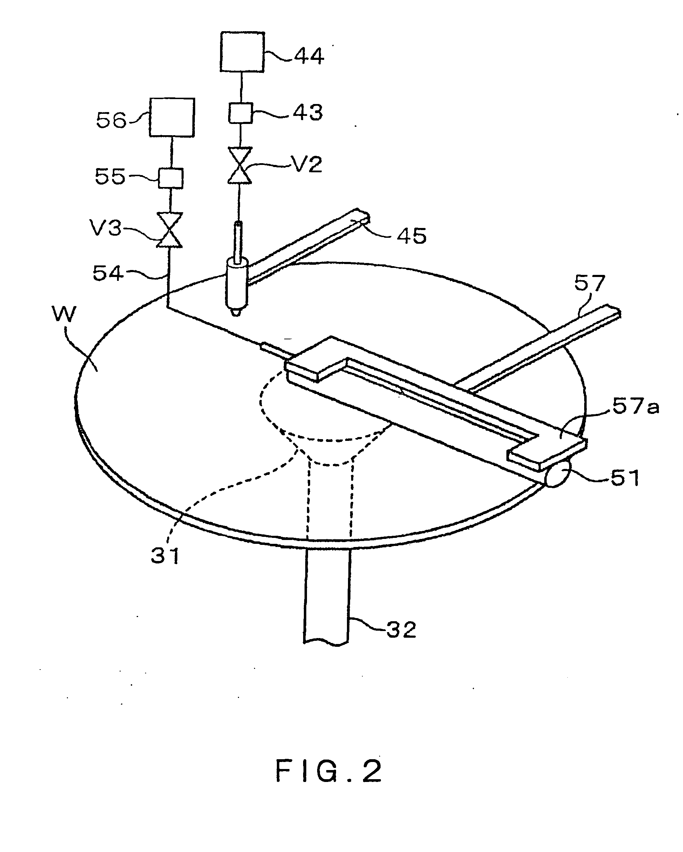

Next, structures of nozzles disposed in the housing 20 are described also with reference to Fig. 2. The reference number 41 depicts a resist supply nozzle disposed as a chemical nozzle, which ejects a resist to a wafer W. Connected to the resist supply nozzle 41 is one end of a resist supply pipe 42. The other end of the resist supply pipe 42 is connected, via a valve V2 and a liquid-flow-rate control part 43, to a resist supply source 44 in which a resist is stored. Also connected to the resist supply nozzle 41 is one end of an arm body 45 that supports the resist supply nozzle 41. The other end of the arm body 45 is connected to a drive part 46. The drive part 46 is configured to be capable of moving along a guide rail 47 arranged horizontally along a longitudinal direction of the housing 20.

In Fig. 1B, the reference number 22 depicts a waiting area of the respective nozzles, disposed on an outside of the cup 34. The waiting area 22 is provided with a bus 22a for waiting the resist supply nozzle 41. When a wafer w is transferred between the spin chuck 31 and the transfer mechanism, the resist supply nozzle 41 and a gas nozzle 51, which is described below, are configured to wait in the waiting area 22. In accordance with the movement of the drive part 46, the resist supply nozzle 41 is structured to be capable of moving, via the arm body 45, from the waiting area 22 to a position above a central portion of the wafer W placed on the spin chuck 31. After the resist supply nozzle 41 is moved to the position above the central portion of the wafer W, the valve V2 is opened, and a flow rate of a resist flowing from the resist supply source 44 into the resist supply pipe 42 is controlled by the liquid-flow-rate control part 43. Thus, the resist at a predetermined flow rate can be ejected onto the central portion of the wafer W from the resist supply nozzle 41.

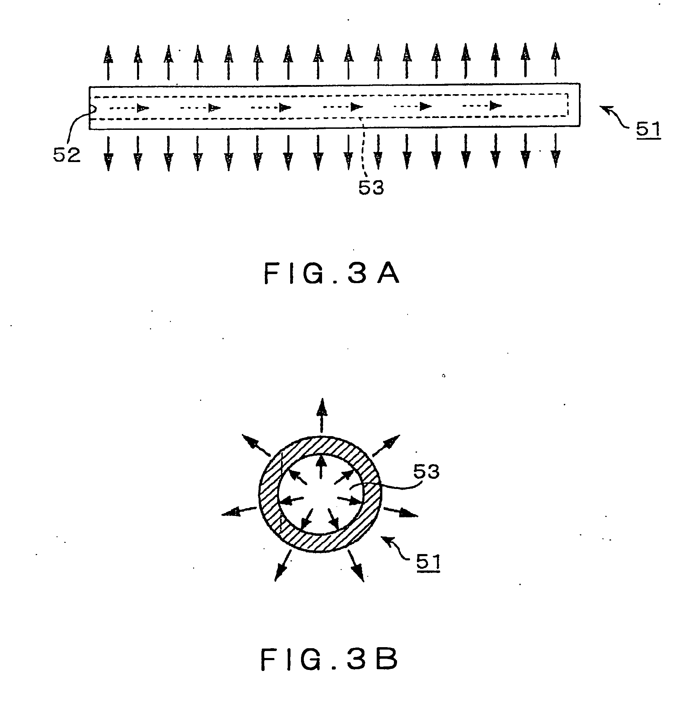

The reference number 51 depicts a gas nozzle that ejects an He gas as a laminar-flow-forming gas to a wafer W. Also with reference to Figs. 3A and 3B, the gas nozzle 51, which is of a cylindrical shape with one end thereof being closed, is formed to have a length (e.g., not less than 150 mm) that is slightly longer than a radius of a wafer W, for example. A gas inlet port 52 is formed in the other end of the gas nozzle 51. The gas inlet port 52 is communicated with a gas channel 53 which is formed in the gas nozzle 51 in a longitudinal direction of the gas nozzle 51.

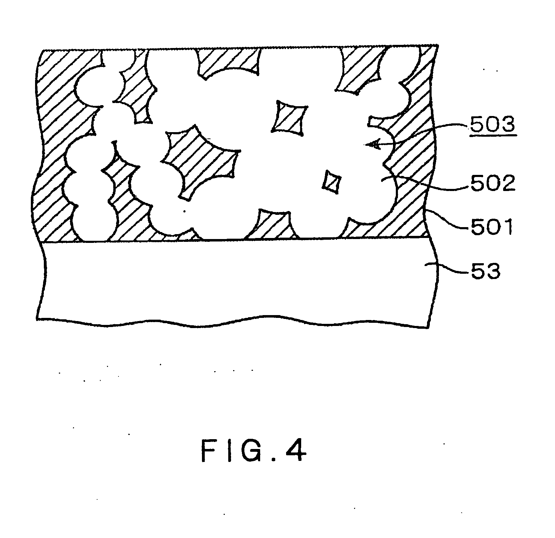

Fig. 4 is a view schematically showing a side peripheral wall of the gas nozzle 51. In Fig. 4, the reference number 501 depicts a body part made of, e.g., alumina ceramics, which constitutes a bone structure of the side peripheral wall. The body part 501 is a porous body, and is adjacent to the gas channel 53. A number of small pores 502 are formed in the body part 501. Many of the pores 502 are communicated with each other, so that a three-dimensionally meshed gas channel 503 is formed in the whole body part 501.

Connected to the gas inlet port 52 of the gas nozzle 51 is one end of a gas supply pipe 54. The other end of the gas supply pipe 54 is connected, via a valve V3 and a gas-flow-rate control part 55, to a gas supply source 56 in which an He gas is stored. By opening the valve V3, the He gas flows from the gas supply source 56 into the gas supply pipe 54. While a flow rate of the He gas is being controlled by the gas-flow-rate control part 55, the He gas flows into the gas channel 53 of the gas nozzle 51. The He gas, which has flown into the gas channel 53, flows into the gas channel 503 of the body part 501 and moves outward the nozzle 51 through the gas channel 503. As described above, the gas channel 503 is formed to have the mesh structure in the whole body part 501. Thus, as shown by the arrows in Figs. 3A and 3B, the He gas, which has passed through the body part 501, is ejected from substantially the overall side peripheral wall of the gas nozzle 51 to the outside of the gas nozzle 51, at substantially a uniform flow speed. The pores 502 in the body part 501 correspond to the ejecting part of the gas nozzle recited in the claims.

As shown in Figs. 1 and 2, the gas nozzle 51 is connected to one end of an arm body 57 through a support member 57a such that the gas nozzle 51 is extended horizontally. The other end of the arm body 57 is connected to a drive part 58 configured to be capable of moving. As described below, when a wafer W is coated with a resist, the gas nozzle 51 together with the drive part 58 is moved, via the arm body 57 and the support member 57a, from the waiting area 22 to an ejecting position for the He gas, which covers the central portion and the radial direction of the wafer W placed on the spin chuck 31, as shown in Fig. 1B and Fig. 2 Then, the He gas is ejected onto the wafer W in the radial direction including the central portion of the wafer W. In Fig. 1, the reference number 100 depicts a control part that is connected to the drive part 33 and the valve V3. The control part 100 controls the drive part 33 and the valve V3 such that the valve V3 is opened at a timing at which the wafer W is started to rotate through the drive part 33 at a rotational speed suitable for drying the resist or a timing prior thereto, and that the valve V3 is closed after a predetermined period has elapsed from the time when the valve V3 was opened.

The ejecting position for the He gas is not limited to the above position. A center of the gas nozzle 51 in a longitudinal direction thereof may be set to be positioned above the central portion of the wafer W. However, it is necessary that the He gas is supplied to the central portion of the wafer W during an initial stage of a step of drying the resist, e.g., for about 10 seconds after the start of the drying step, which is described below. An air flowing downward toward the wafer W spirally flows, by a centrifugal force of the wafer W, from the central side of the wafer W toward the peripheral side of the wafer W. When an He gas is ejected to the center of the wafer W, the ejected He gas merges into the air flow and runs through toward the peripheral side of the wafer W. Thus, a layer of a mixed gas containing the air and the He gas is formed all over the surface of the wafer W. A coefficient of kinematic viscosity of this layer is higher than a coefficient of kinematic viscosity of the sole air. Therefore, generation of transition flow on the wafer W can be restrained.

When the gas nozzle 51 is moved to the position at which the He gas is ejected, a height h from a lower end of the nozzle 51 to the surface of the wafer W, which is shown in Fig. 1, is preferably between 0.2 mm and 70 mm, when the wafer W is rotated at 2600 rpm or at 3000 rpm for drying the resist that has been supplied to the wafer W, for example, although the height h may vary depending on a mixed ratio of the air and the He gas in the mixed-gas layer. When the h is smaller than 0.2 mm, the gas nozzle 51 may come into contact with the wafer W. In addition, there is a possibility that a gas flow formed on the wafer W is disturbed by the gas nozzle 51, so that an evaporation and drying speed of the resist in respective portions of the wafer W becomes unstable or non-uniform. This may make non-uniform a thickness of a resist film to be formed. On the other hand, when the h is larger than 70 mm, a longer time period may be required before the air on the wafer W is replaced with the He gas. In addition, when the He gas is supplied to the wafer W, there is a possibility that a coefficient of kinematic viscosity of the gas on the peripheral portion of the wafer W cannot be sufficiently increased, failing to achieve the effect of the present invention sufficiently.

As shown in Fig. 1A, a filter 61 for removing particles is disposed at an upper part of the housing 20. A ventilation chamber 62 as a defined (closed) space is formed on the upper part of the filter 61. One end of a gas supply pipe 63 is opened to the ventilation chamber 62. The other end of the gas supply pipe 63 is connected, via a valve V4, to an air supply source 64 in which an air as an atmospheric gas is stored. By opening the valve V4, the air in the air supply source 64 flows, at a predetermined flow rate, for example, into the ventilation chamber 62 through the gas supply pipe 63. After the air that has flown into the ventilation chamber 62 passes through the filter 61 so that particles included in the air are removed, the air is adapted to be supplied into the housing 20. The filter 61, the gas supply pipe 63, and the gas supply source 64 correspond to the gas-flow-forming unit recited in the claims.

In addition, although not shown, a gas-discharging part that discharges any gas in the housing 20 is disposed at a lower part of the housing 20. As described above, an air is supplied from the filter 61, and the gas-discharging part discharges, independently from the gas-discharging unit 30, the air at a predetermined flow rate, for example, so that a down flow of the air can be formed in the housing 20.

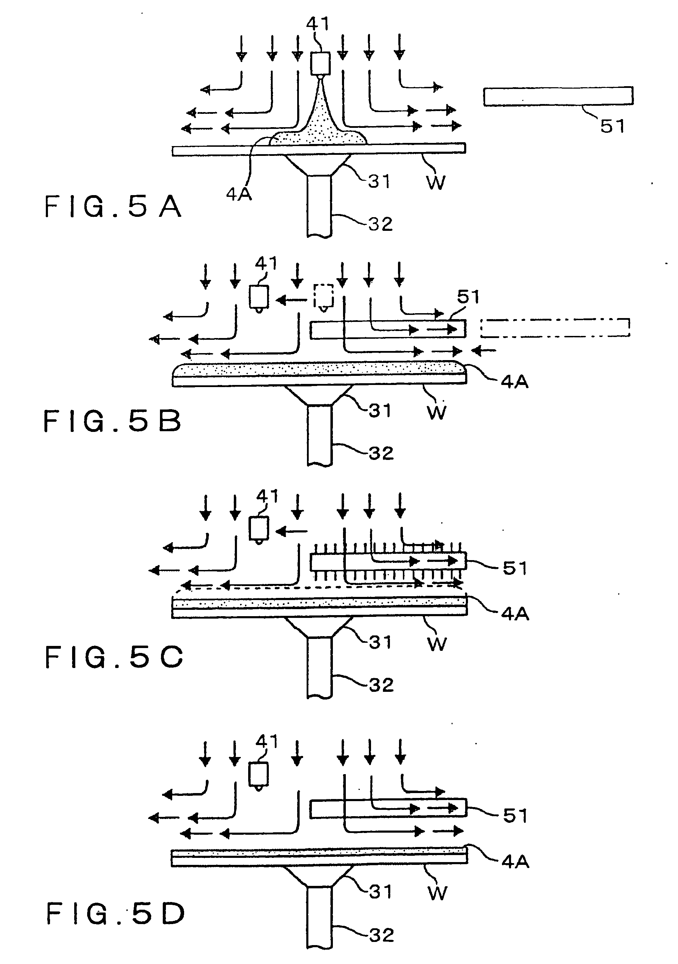

Next, an operation of the coating apparatus 2 in this embodiment is described with reference to Figs. 5A to 5D.

At first, the valves V4 and V1 are opened, and an air is discharged from the gas-discharging part at the lower part of the housing 20, so that down flows of the air are formed in the housing 20 which are indicated by the solid arrows in Figs. 5A to 5D. Following thereto, the transfer mechanism, not shown, with holding a wafer W, enters the housing 20 via the transfer port 21. Simultaneously, the spin chuck 31 is raised to the outside of the cup 34, for example, through the drive part 33. Then, the spin chuck 31 attract a central portion of a rear surface of the wafer W and holds the wafer W horizontally. Thereafter, the spin chuck 31 is lowered so that the wafer W is received in the cup 34. After that, the resist supply nozzle 41 is moved via the drive part 46 to a position above the central portion of the wafer W, and the gas nozzle 51 is moved via drive part 58 to a position close to the peripheral edge of the wafer W.

Subsequently, the wafer W held on the spin chuck 31 is rotated through the drive part 33 about a vertical axis at 2000 rpm, for example. Thus, the down flow of the air falling upon the wafer W is spirally spread out on the rotating wafer W toward the peripheral portion thereof because of the centrifugal force. Then, the valve V2 is opened, so that a resist 4A supplied from the resist supply nozzle 41 is ejected to the central portion of the wafer W. The resist 4A that has been supplied to the wafer W is spread out from the central portion of the wafer W toward the peripheral portion thereof by a so-called spin coating for extending the resist by the centrifugal force (Fig. 5A).

After the overall surface of the wafer W is covered with the resist 4A, the valve V2 is closed so that the supply of the resist 4A from the resist supply nozzle 41 is stopped, and the rotational speed of the spin chuck 31 is lowered to, e.g., 100 rpm. Thus, leveling of the coated resist 4A (to level the coated resist so as to make uniform a thickness thereof) is performed. In addition, at this time, the resist supply nozzle 41 is retracted via the drive part 46 from the position above the center of the wafer W, and the gas nozzle 51 is moved to the aforementioned He-gas ejecting position (Fig. 5B).

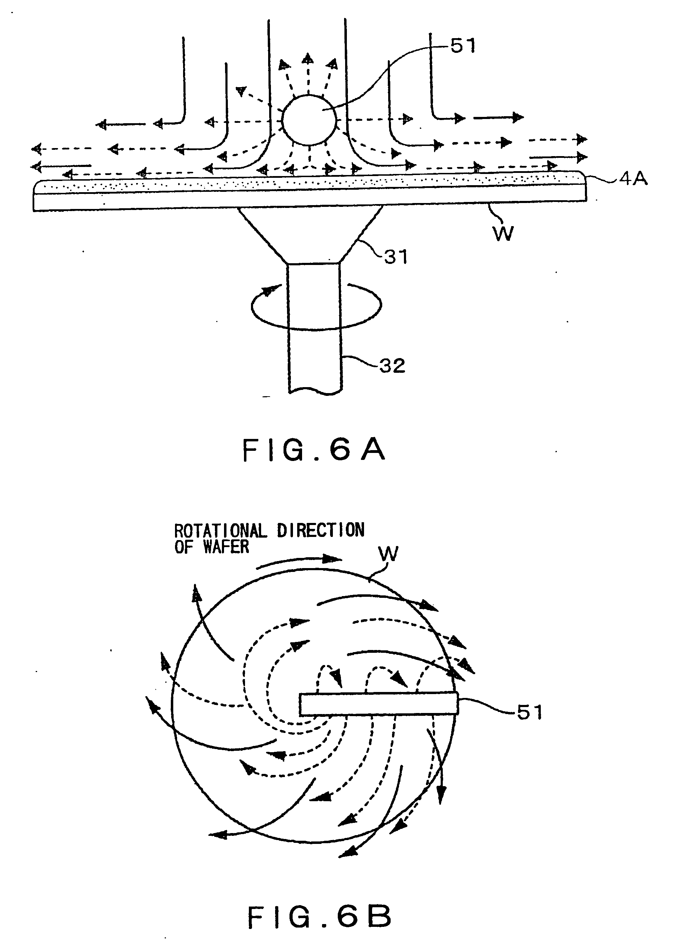

After the movement of the gas nozzle 51, the valve V3 is opened, and, while a flow rate of an He gas to be supplied from the He-gas supply source 56 to the gas supply pipe 54 is being controlled by the flow-rate control part 55, the He gas is ejected in a shower-like manner from the peripheral surface of the porous body as the gas nozzle 51. The He gas is supplied in the radial direction of the wafer W including the central portion thereof, at a flow rate of, e.g., 40 L/min. Simultaneously with the ejection of the He gas or slightly after the ejection thereof, the rotational speed of the wafer W is increased to, e.g., 2600 rpm, so that the resist 4A is spun out and dried (see, Fig. 5C). Figs. 6A and 6B are views showing flows of the respective gases in the vicinity of the wafer W, when the He gas is ejected to the wafer W. The flows of the He gas are indicated by the dotted lines, and the flows of the air are indicated by the solid lines, respectively. As shown in these drawings, the He gas that has been supplied onto the wafer W merges into the air that has been spirally spread out along the surface of the wafer W from the center thereof, and forms a spiral flow, so that a layer of a mixed gas formed of the He gas and the air is spread out on the wafer W toward the peripheral portion thereof. Due to the spiral flow, a solvent is actively evaporated from the resist on the wafer W, so that the resist 4A is dried. Thus, a resist film as a coating film is formed. In Fig. 5C, the dotted line depicts the layer of the mixed gas.

After a time sufficient for the solvent in the resist to be evaporated has passed, e.g., after further 10 seconds have passed, the valve V3 is closed to stop the supply of the He gas, while the rotation of the wafer is maintained as it is (see, Fig. 5D). After the stop of the supply of the He gas, the spin chuck 31 is rotated for a while at the same speed so as to continue the drying process of the resist 4A. Then, after 60 seconds have elapsed from when the rotation had been started at the rotational speed suitable for drying, the rotation of the spin chuck 31 is stopped. Thereafter, the wafer is delivered to the transfer mechanism in the reverse manner to that for loading the wafer W, which has been described above, and the wafer W is unloaded from the housing 20 by the transfer mechanism.

The coating apparatus 2 in this embodiment performs the spin coating of the resist on the surface of the wafer W. Then, in order to dry the resist film, while forming the down flow of the air, the coating apparatus 2 supplies the He gas as a laminar-flow-forming gas, which has a coefficient of kinematic viscosity larger than that of the air, in the radial direction of the wafer W including the center of the surface thereof, before the wafer W is rotated at the rotational speed (2600 rpm in this embodiment) suitable for drying the resist film. Thus, the He gas is mixed into the air flowing downward toward the central portion of the wafer W and spreading out along the surface of the wafer W from the central portion to the peripheral portion thereof, and the thus mixed gas is diffused all over the surface of the wafer W. Therefore, the coefficient of kinematic viscosity of the gas flow on the surface of the wafer W becomes 1.5 to 4 times larger than that of the sole air. Since a radius of the laminar-flow area formed on the surface of the wafer W is in proportion to a coefficient of kinematic viscosity of the gas, the laminar-flow area is widened so that even a 12-inch wafer can be completely covered within the laminar-flow area.

In addition, the solvent of the resist film actively evaporates immediately after the rotational speed of the wafer W is increased to the rotational speed for drying. At the same time, in the spiral flow flowing along the surface of the wafer W, a gas flow close to the surface of the wafer W is formed by the gas supplied to the central portion of the wafer W, and there is stacked, on the gas flow, another gas flow of the gas supplied to a portion on an outside of the central portion of the wafer W. Thus, a finished condition of the resist film is generally determined by the flow of the gas supplied to the central portion of the wafer W immediately after the rotational speed of the wafer W reaches the rotational speed for drying. In this embodiment, when the wafer starts to rotate at the rotational speed for drying, the He gas has been supplied to the central portion of the wafer W. Thus, generation of windmill-like tracks on the surface of the wafer W can be effectively restrained, to thereby realize an improved coating process. Namely, according to this embodiment, even when a larger wafer W is used, generation of windmill-like track can be restrained or avoided.

Further, since the supply of the laminar-flow-forming gas to the surface of the wafer W is performed by the gas nozzle, consumption of the gas can be reduced as compared with a case in which the whole atmosphere, where the wafer W is placed, is replaced with the He gas or the like. In addition, a long time period for the replacement of the gas can be saved. Moreover, the wafer W is located in the down-flow atmosphere, and the air around the wafer W is discharged. Thus, there can be eliminated the problem associated with a method in which a lid is disposed above the wafer W so as to form a closed space, i.e., there is no possibility that mists scattered from the wafer W adhere to the lid to become particles.

Furthermore, since the gas nozzle 51 is configured to eject a gas through the porous body (voids formed by the porous body serve as a gas ejecting part), the He gas can be uniformly supplied to the surface of the wafer W in a shower-like manner. Thus, a pressure distribution of the He gas on the surface of the wafer W can be made uniform. Also for this reason, the dried resist film can have a smooth surface, which improves a finish of drying.

The atmospheric gas stored in the supply source 64 is not limited to the air. For example, a nitrogen gas or an Ar (argon) gas may be stored, and a down flow of the nitrogen gas or the Ar gas may be formed in the housing 20.

In addition, the gas ejected from the gas nozzle 51 as the laminar-flow-forming gas may be any gas that has a coefficient of kinematic viscosity larger than that of another gas used as the atmospheric gas. Thus, for example, a gas such as hydrogen may be used in place of the He gas. In addition, as the laminar-flow-forming gas, a mixed gas formed of an He gas and an air, or a mixed gas formed of an He gas and a nitrogen gas, may be used.

In the above-described embodiment, the He gas is supplied when the rotational speed of the wafer W is increased, after the resist that has been supplied to the wafer W is leveled. However, as long as the layer of the mixed gas including the He gas and the air is formed on the surface of the wafer W before almost all the solvent is evaporated after the rotational speed of the wafer W was increased after the leveling, the effect of the present invention can be achieved. Thus, it is possible to start the ejection of the He gas to the wafer W in the course of the leveling and to stop the ejection after almost all the solvent is evaporated. However, as in the above embodiment, the case in which the rotational speed of the wafer W is increased for the drying step after the leveling and then the ejection of the He gas is started at the time when or immediately before the drying step is started, is preferable to the case in which the ejection of the He gas to the wafer W is started during the leveling. This is because an effect caused by the He gas on a temperature of the wafer W can be restrained, so that there can be obtained a resist film having a more improved in-plane uniformity.

Suppose that a planar area (size) of the wafer W to be coated is S1 and a projection area of the nozzle 51 on the wafer when the He gas is supplied to the wafer W is S2, the projection area S2 equals to an area of the lower end surface of the nozzle 51, in the case of this embodiment. The smaller a ratio of S2 relative to S1 (S2/S1) is, the less adhesion of the resist, which has been scattered and made misty during the rotational coating process, can be caused. Namely, since the resist can be prevented from falling on the wafer W as particles, a smaller ratio of S2 relative to S1 (S2/S1) is preferred. Thus, even when the value of S2 is increased, S2/S1 is preferably not more than 1/2.

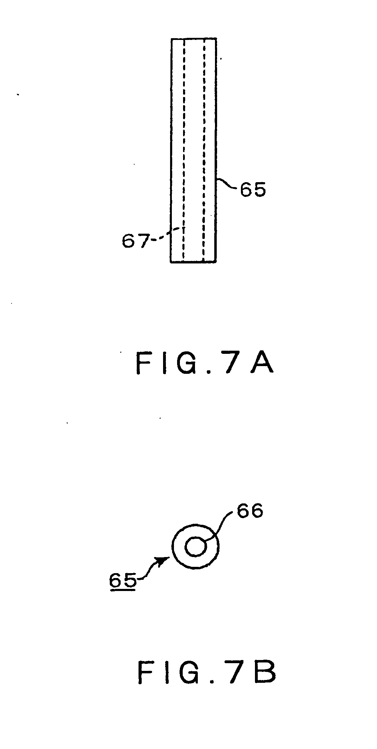

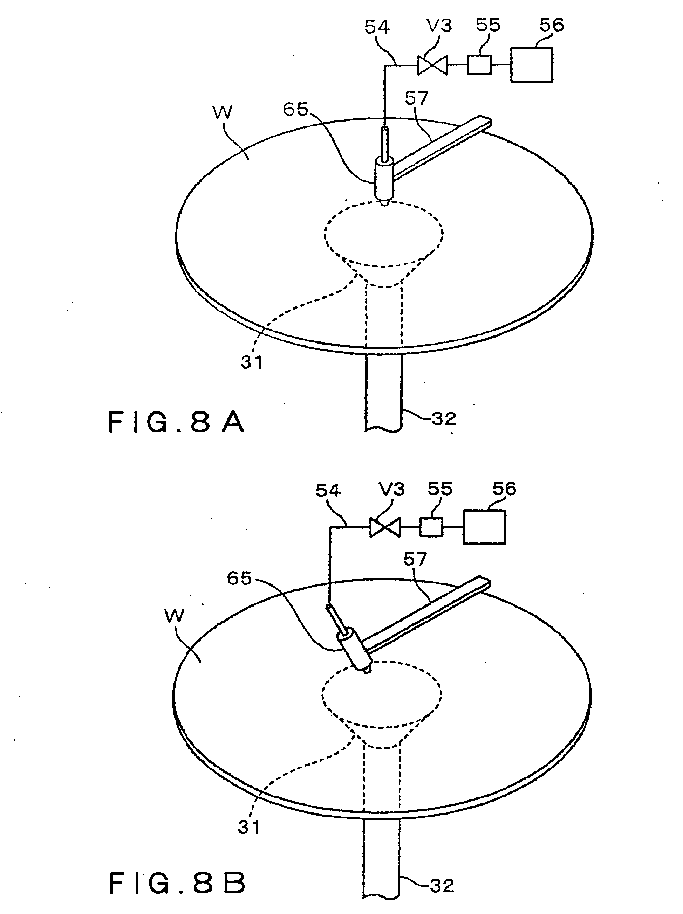

As the gas nozzle, it is preferable to use the gas nozzle 51 made of a porous body, as described above. However, gas nozzles having structures shown in Fig. 7A and so on may be used. Figs. 7A and 7B respectively show a side view and a bottom view of another gas nozzle 65. The gas nozzle 65 is formed into a cylindrical shape. The reference number 66 depicts an ejecting part. The reference number 67 depicts a gas channel that is formed in the gas nozzle 65 along a longitudinal direction of the gas nozzle 65. The gas channel 67 is communicated with the ejecting part 66. The gas nozzle 65 is connected to the arm body 57 such that one end of the gas supply pipe 54 is connected to the gas channel 67 and that the ejecting part 66 faces the central portion of the wafer W when the gas nozzle 65 ejects an He gas to the wafer W. As shown in Fig. 8A, for example, the gas nozzle 65 may take an upright posture such that a gas ejected from the ejecting part 66 is directed vertically toward the central portion of the surface of the wafer W. Alternatively, as shown in Fig. 8B, for example, the gas nozzle 65 may take a posture that is diagonally downward inclined above the wafer W to eject a gas toward the central portion.

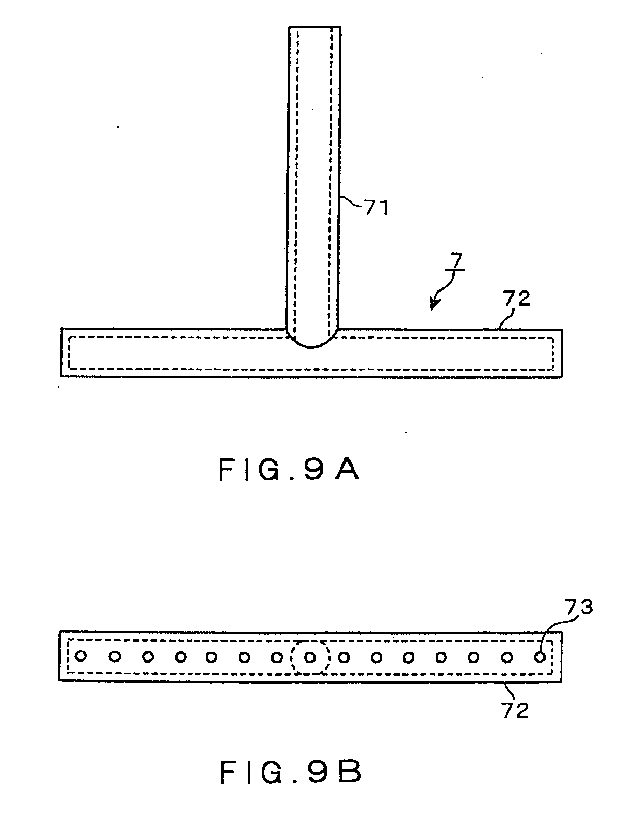

The gas nozzle for supplying an He gas may be a gas nozzle 7 having a structure as shown in Figs. 9A and 9B, for example. Figs. 9A and 9B respectively show a front view and a bottom view of the gas nozzle 7. The gas nozzle 7 is of an inverted T-shape including a cylindrical vertical base part 71 forming a gas channel to be connected to the aforementioned gas supply pipe 54, and a gas supply part 72 as a horizontal pipe. A lower end of the base part 71 is connected to the gas supply part 72 at a central portion in a longitudinal direction of thereof. In a bottom surface of the gas supply part 72, there is formed an ejecting part 73 consisting of a large number of holes that are arranged over all the length of the gas supply part 72 at intervals.

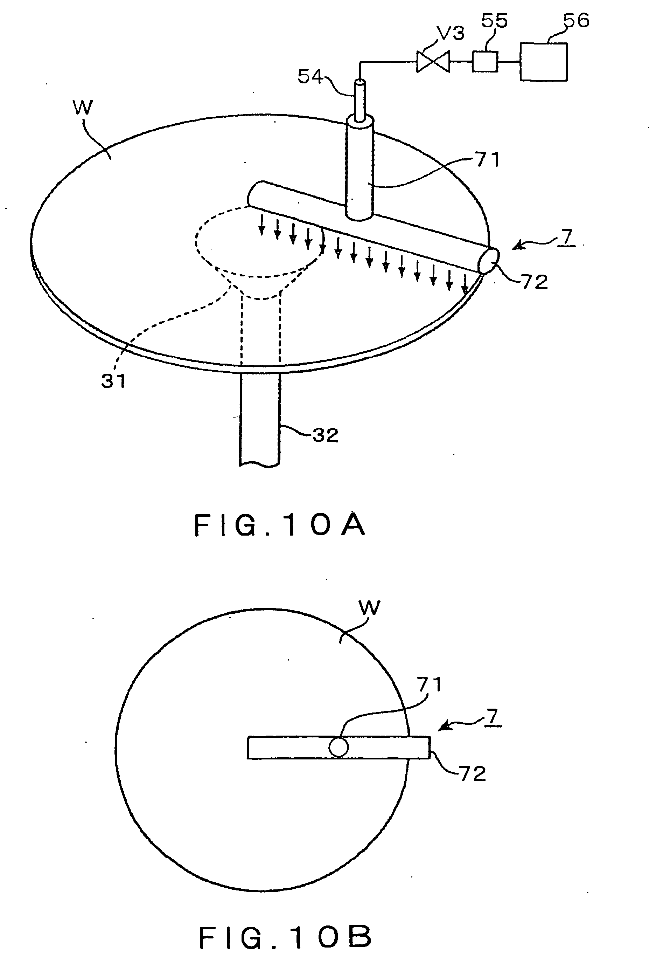

As shown in Figs. 10A and 10B, the gas nozzle 7 is disposed such that, when the nozzle 7 ejects an He gas to the wafer W, each of the holes of the ejecting part 73 is opposed to the surface of the wafer W, with one end of the gas supply part 72 being located above the central portion of the wafer W and the other end thereof being located above the peripheral portion of the wafer W so as to cover the radius of the wafer W. Thus, an He gas supplied from the gas supply pipe 54 to the gas nozzle 7 is ejected directly downward from the ejecting part 73, as indicated by the arrows in Fig. 10A, so as to be supplied along the radial direction of the wafer W including the central portion thereof.

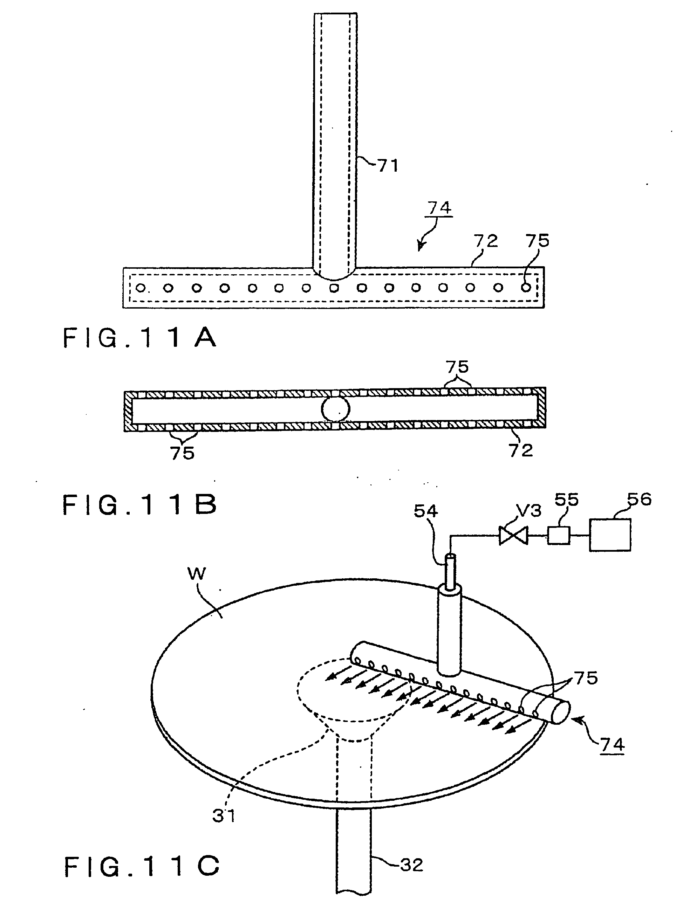

Alternatively, the gas nozzle may have a structure as shown in Figs. 11A and 11B, for example. Figs. 11A and 11B respectively show a front view and a transversal plan view of a gas nozzle 74. The gas nozzle 74 is structured substantially similarly to the above gas nozzle 7. However, an ejecting part 73 is not formed in a lower surface of a gas supply part 72, but ejecting parts 75 consisting of a large number of holes, which are arranged along the overall longitudinal direction of the gas supply part 72 at intervals, are formed in opposed side surfaces of the gas supply part 72. As shown in Fig. 11C, for example, the gas nozzle 74 is disposed such that, when the gas nozzle 74 ejects an He gas to the wafer W, the He gas is horizontally ejected from each of the holes of the ejecting part 75, and that the ejected He gas passes a position above the central portion of the wafer W along the surface of the wafer W. Herein, when a distance between each ejecting part 75 and the wafer W is large, the effect of the present invention cannot be obtained. Thus, the distance between a center of each ejecting part 75 and the wafer W is set, for example, between 5 mm and 15 mm.

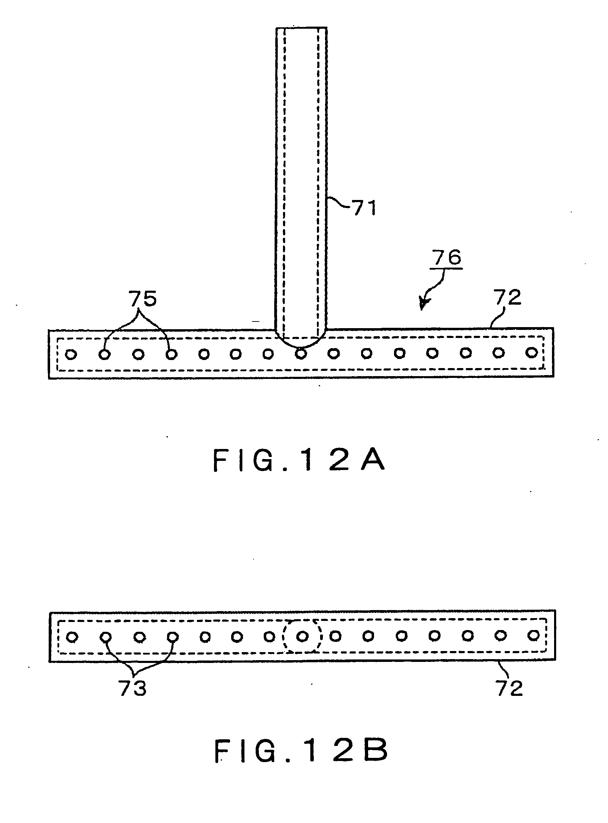

Alternatively, the gas nozzle may have a structure as shown in Fig. 12, for example. Fig. 12A and 12B respectively show a front view and a bottom view of a gas nozzle 76. The gas nozzle 76 is structured substantially similarly to the gas nozzle 7 as shown in Figs. 9A and 9B. However, in addition to a gas ejecting part 73, ejecting parts 75 consisting of a large number of holes, which are arranged along the overall longitudinal direction of a gas supply part 72 at intervals, are formed in opposed side surfaces of the gas supply part 72. Similarly to the gas nozzle 7 shown in Figs. 9A and 9B, the gas nozzle 76 is disposed such that, when the gas nozzle 76 supplies an He gas to the wafer W, the gas supply part 72 covers the center of the wafer W and the radius thereof. Thus, simultaneously with an He gas being horizontally ejected from the ejecting parts 75, the He gas is ejected directly downward from the ejecting part 73.

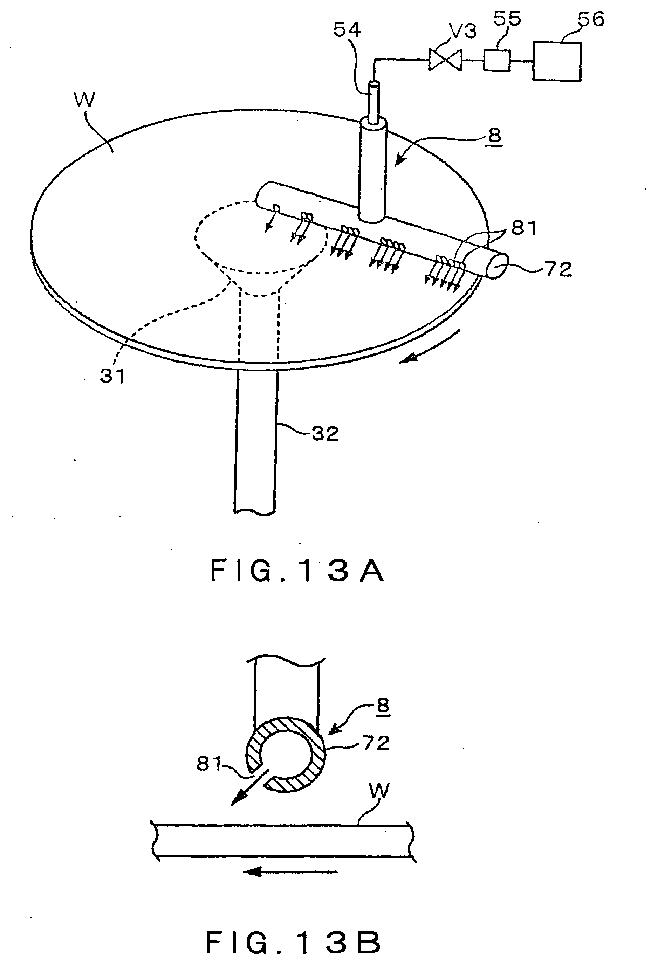

Herein, at a position further from the central portion of the wafer W and thus closer to the peripheral portion thereof, the length of the wafer W in the circumferential direction is greater. Thus, in order to uniformize a density of the He gas within the plane of the wafer W, it is preferable to make larger the flow rate of the He gas depending on the position, by a distance thereof from the central portion of the wafer W toward the peripheral portion thereof. To be specific, it is preferable to supply an He gas to the wafer W by means of a gas nozzle 8 as shown in Fig. 13A. The gas nozzle 8 is structured substantially similarly to the above gas nozzle 7. That is to say, similarly to the gas nozzle 7, the gas nozzle 8 is configured such that, when the gas nozzle 8 ejects an He gas to the wafer W, a gas supply part 72 covers at least one radius of the wafer W. However, in place of the holes of the ejecting part 73 which are uniformly arranged, there is provided an ejecting part 81 consisting of holes of the same bore such that the holes are arranged along a longitudinal direction of a gas supply part 72 but an arrangement density of the holes is different, greater at a position closer to the peripheral side of the wafer W. In this example, as shown in Figs. 13A and 13B, each of the holes of the ejecting part 81 is arranged so as to eject an He gas diagonally downward along the rotational direction of the wafer W. However, each of the holes of the ejecting part 81 may be arranged so as to eject an He gas in a direction reverse to the rotational direction of the wafer W. Further, not limited to the diagonally downward ejection, an He gas may be ejected directly downward so as to be supplied to the wafer W in the radial direction of the wafer W including the central portion thereof. Furthermore, the arrangement density of the holes of the ejecting part 81 may be set such that a flow rate of the He gas to be supplied to each portion of the wafer W is in proportion to a distance from the center of the wafer W.

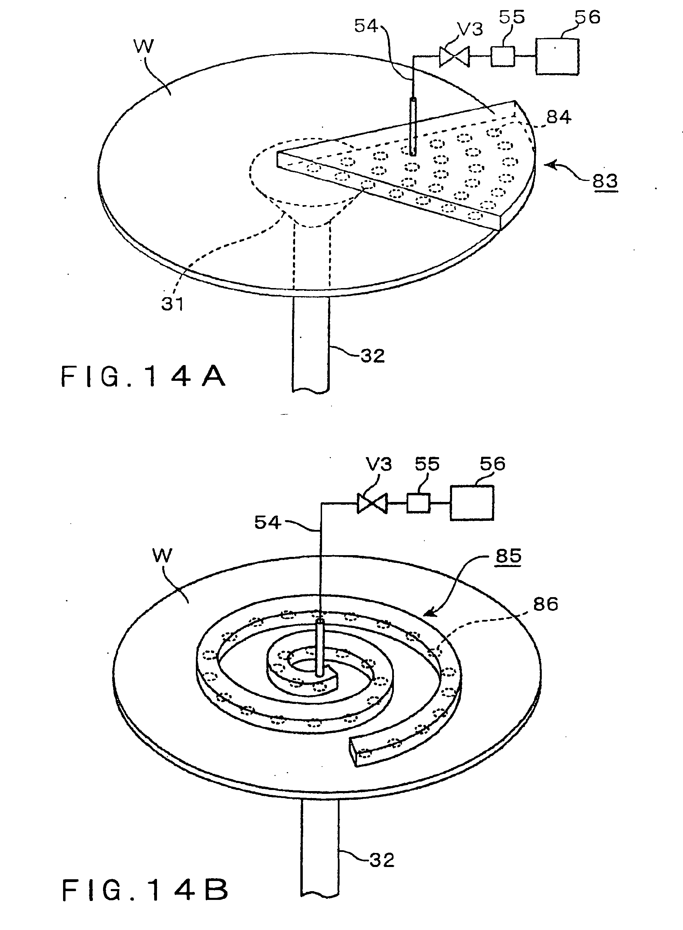

In addition, a gas nozzle 83 as shown in Fig. 14A may be used. The gas nozzle 83 is formed to have a hollow sectoral block structure. The gas supply pipe 54 is connected to an upper part of the gas nozzle 83. There is provided an ejecting part 84 consisting of a large number of holes of the same bore, which are opened at intervals over all the lower surface of the sectoral block, e.g., in a radial direction and a circumferential direction of the sectoral block. From the inside to the outside, the number of the holes of the ejecting part 84 in the circumferential direction is gradually increased. The hole of the ejecting part 84 arranged on the innermost side is configured to eject an He gas to the central portion of the wafer W.

In addition, as shown in Fig. 14B, there may be used a gas nozzle 85 that is formed to have a hollow block structure to define a spiral shape in the forward direction with respect to the rotational direction of the wafer W. Provided in a lower surface of the gas nozzle 85 is an ejecting part 86 consisting of a large number of holes of the same bore, which are arranged at intervals, for example. The ejection flow rate of the He gas is greater at an area closer to the peripheral side of the wafer W.

In order to increase the ejection flow rate of the He gas at the position closer to the peripheral side of the wafer W, it is adoptable to, for example, make each gas nozzle such that the hole of the ejecting part arranged closer to the peripheral side has a greater diameter, in addition to adoption of the structure in which the holes of the same bore arranged closer to the peripheral side have a greater arrangement density. Furthermore, in place of the aligned small holes, there may be formed a slit extending in a longitudinal direction of the gas supply part (e.g., gas supply part 72). In this case, in order to increase the ejection flow rate of the He gas at the position closer to the peripheral side of the wafer W, a width of the slit is preferably enlarged in a stepless or stepwise manner toward the peripheral edge of the wafer W.

Alternatively, in the gas nozzles 83 and 85 shown in Figs. 14A and 14B, it is possible to form a lower wall part facing the wafer W into a porous structure, similarly to the side peripheral wall of the aforementioned gas nozzle 51, so that an He gas can be ejected downward from substantially the whole lower wall part at a substantially uniform flow speed.

In addition, when an He gas is supplied to the wafer W by the aforementioned gas nozzle 65, the supply position of the He gas may be moved from the central portion toward the peripheral portion. Specifically, as shown in Fig. 8A, during a time period starting from when the drying step was started and finishing when 10 seconds have passed, the gas nozzle 65 may be positioned above the central portion of the wafer W to thereby supply the He gas to the central portion of the wafer W, and thereafter, the gas nozzle 65 may be horizontally moved to a position above the peripheral portion of the wafer W and stopped there, for example, to thereby supply the He gas to the peripheral portion. Further, it is possible to make the gas nozzle 65 to be capable of rotating in a horizontal plane, so that the point at which an He gas is supplied can be moved from the central portion of the wafer W toward the peripheral portion of the wafer W.

Not limited to the case in which a resist is supplied to a substrate to deposit thereon a film, the coating apparatus 2 in this embodiment may be used when a substrate is coated with a chemical containing a precursor of an insulation film so as to deposit on the substrate the insulation film such as a silicon oxide film. Namely, the coating apparatus 2 in this embodiment can be widely applied to any case in which a substrate is coated with a general chemical.

<Examples>

In Example 1, there was prepared a coating apparatus in which, in place of a resist, an oil liquid formed by mixing a commercially available liquid ink and a commercially available neutral detergent (trade name: mama lemon) at a ratio of 1 : 1 was stored in a supply source 44, and the thus formed oil liquid in place of a resist was supplied from a liquid supply nozzle 41 to a wafer W. The other structures of the coating apparatus are the same as those of the aforementioned coating apparatus 2.

In accordance with the procedure for applying a resist in the aforementioned embodiment, the oil liquid was applied onto a wafer W, and an oil film was formed by the oil liquid.

As the wafer W, a 300-mm wafer (12-inch wafer) was used (all the wafers W used in the following examples have a diameter of 300 mm). As a gas nozzle for ejecting an He gas, the gas nozzle 65 as shown in Fig. 7A was used. A gas-discharging flow rate in a housing 20 during the coating process of the oil liquid was 2 $m^3$/min. In accordance with the procedure substantially the same as in the aforementioned embodiment, oil droplets were made to drop from the liquid supply nozzle 41 and an oil film was formed on the wafer W. A time period starting from when the dropping of the oil droplets was started and finishing when the leveling was completed, was 20 seconds. The drying step succeeding the leveling was performed for 60 seconds, with the rotational speed of the W being set at 3000 rpm. From beginning to end of the drying step, the gas nozzle 65 was located at a position as shown in Fig. 8A, and an He gas was ejected to the central portion of the wafer W for 60 seconds. A height from the surface of the wafer W to an ejecting port 66 of the gas nozzle 65 when the gas nozzle 65 ejects an He gas, was 2.5 mm, and a flow rate Qin of the He gas was 33 L/min.

The thus formed oil film was evaluated, and neither windmill-like track nor ejection trajectory of the He gas was observed on the surface.

Next, as Example 2, an oil film was formed by supplying an oil liquid to a wafer W, in the same manner as Example 1, with the use of the gas nozzle 74 as shown in Figs. 11A and 11B. When an He gas was supplied to the wafer W, the He gas was ejected to pass a position above the central portion of the wafer W along the surface of the wafer W as described in Fig. 11C.

In Example 2, there were performed a coating process with a value of the flow rate Qin of the He gas to be supplied to the wafer W being set at 19 L/min, and a coating process with a value of the flow rate Qin being set at 38 L/min, and thus formed oil films were evaluated. When the flow rate Qin was set at 19 L/min, windmill-like tracks were formed on the oil film. On the other hand, when the flow rate Qin was 38 L/min, neither windmill-like track nor ejection trajectory of the He gas was observed on the oil film.

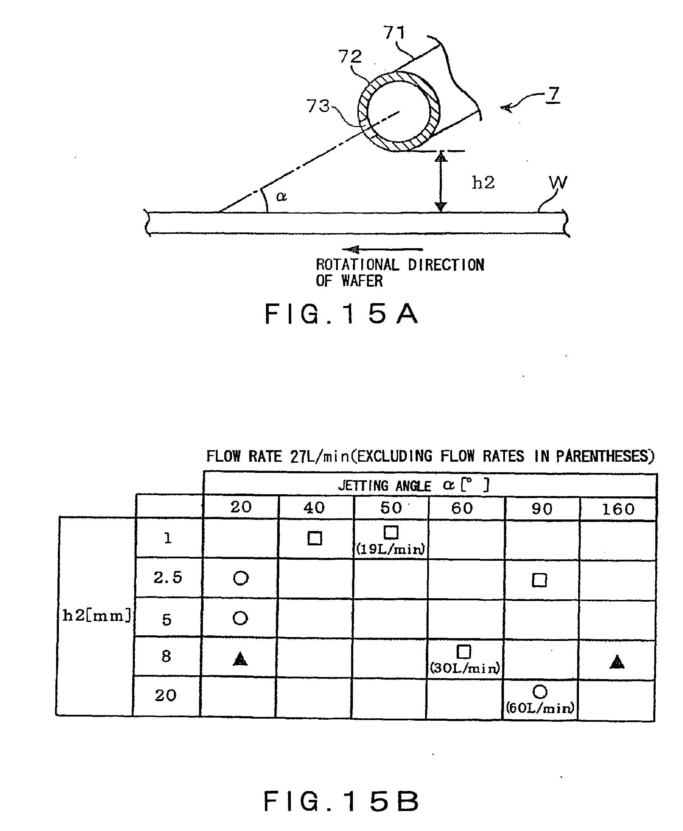

Next, as Example 3, with the use of the gas nozzle 7 as shown in Figs. 9A and 9B, oil films were formed on wafers W, in accordance with the same procedure as Example 1, with a height h2 from the lower end of the gas nozzle 7 to the surface of the wafer W, and an angle α defined between an orientation of the center of an ejecting part 73 and an orientation of the rotation of the wafer W being changed, as shown in Fig 15A. The evaluation results of the respective oil films are shown in the table of Fig. 15B. In the table of Fig. 15B, the axis of abscissa shows the values of the angle α, and the axis of ordinate shows the values of the height h2. The mark ○ in the table represents that neither windmill-like track nor ejection trajectory of the He gas was formed on the formed oil film. The mark □ represents that an ejection trajectory of the He gas was formed while no windmill-like track was formed. The mark ▲ represents that windmill-like tracks were formed while no ejection trajectory of the He gas was formed. In Example 3, when the angle α was 50˚ and the height h2 was 1 mm, the flow rate of the He gas was 19 L/min. When the angle α was 60˚ and the height h2 was 8 mm, the flow rate of the He gas was 30 L/min. When the angle α was 90˚ and the height h2 was 20 mm, the flow rate of the He gas was 60 L/min. When the angle α and the height h2 took other values, the flow rate of the He gas was 27 L/min.

As shown in Fig. 15B, by adjusting the angle α and the flow rate of the He gas at the height h2 between 1 mm and 20 mm, formation of windmill-like tracks could be prevented. As shown in the table, depending on the values of the height h2 and the angle α, a groove-like ejection trajectory of the He gas was formed on some wafers W in the circumferential direction thereof. Such an ejection trajectory is formed at a point where a pressure is applied by the He gas colliding with the wafer W. Thus, it can be considered that such a formation of the ejection trajectory can be prevented by forming the ejecting part 73 into a slit-like shape so that the He gas can be ejected therefrom to cover the central portion of the wafer W and the radius thereof, or by, in place of the provision of the ejecting part 73, forming the peripheral wall of the gas supply part 72 as a horizontal pipe into a porous structure, as in the aforementioned gas nozzle 51, so that the He gas can be ejected from holes of the porous stru ctu re.

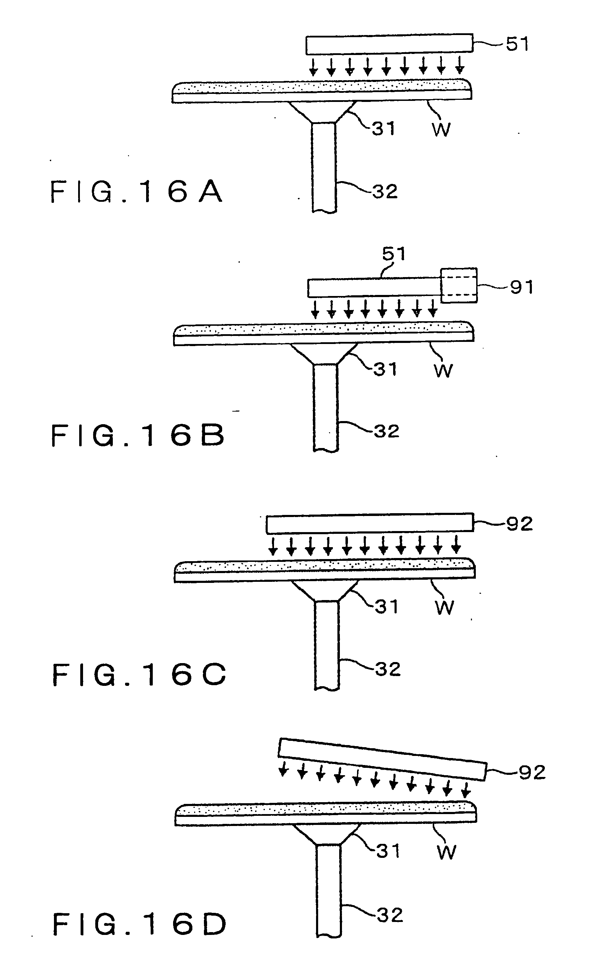

Next, as Example 4-1, by using the coating apparatus 2 shown in the aforementioned embodiment, an ArF resist film was deposited on a wafer W in accordance with substantially the same procedure as in the above embodiment. At the drying step after the leveling of the dropped resist, as shown in Fig. 16A, with the use of the gas nozzle 51 (see, Figs. 1 to 3) as described in the aforementioned embodiment, an He gas was ejected over the length from the central portion to the peripheral portion of the wafer W along the radial direction thereof. The rotational speed of the wafer W at the drying step was 2600 rpm, and the flow rate of the He gas was 40 L/min. The distance between the lower end of the gas nozzle 51 and the wafer W, which is indicated as h in Fig. 1, was 2 mm.

In addition, as Example 4-2, a resist film was deposited on a wafer W in accordance with substantially the same procedure as in the above Example 4-1. However, as shown in Fig. 16B, the end of the gas nozzle 51 in Example 4-2, which was positioned above the peripheral portion of the wafer W when the gas nozzle 51 ejected an He gas, was covered with a cover 91, such that no He gas was ejected to the peripheral portion of the wafer W.

Next, as Example 4-3, a resist film was deposited on a wafer W in substantially the same manner as the above Examples 4-1 and 4-2. In Example 4-3, the gas nozzle 92 was used in place of the gas nozzle 51. The gas nozzle 92 has the same structure as that of the gas nozzle 51, excluding that the peripheral wall of the gas nozzle 92 is longer than that of the gas nozzle 51. As shown in Fig. 16C, the gas nozzle 92 has a sufficient length such that one end of the gas nozzle 92 is positioned above the peripheral portion of the wafer W and that the other end thereof fully covers the central portion of the wafer W, when the gas nozzle 92 ejects an He gas to the wafer W. The gas nozzle 92 is horizontally disposed above the diameter of the wafer W.

Further, as Example 4-4, a film-deposition process of a resist film was performed similarly to Example 4-3, by using the gas nozzle 92 similar to Example 4-3. However, as shown in Fig. 16D, when the gas nozzle 92 ejected an He gas, the gas nozzle 92 was disposed in an inclined manner such that one end thereof which was positioned above the central side of the wafer W was higher than the other end thereof which was positioned above the peripheral edge of the wafer W.

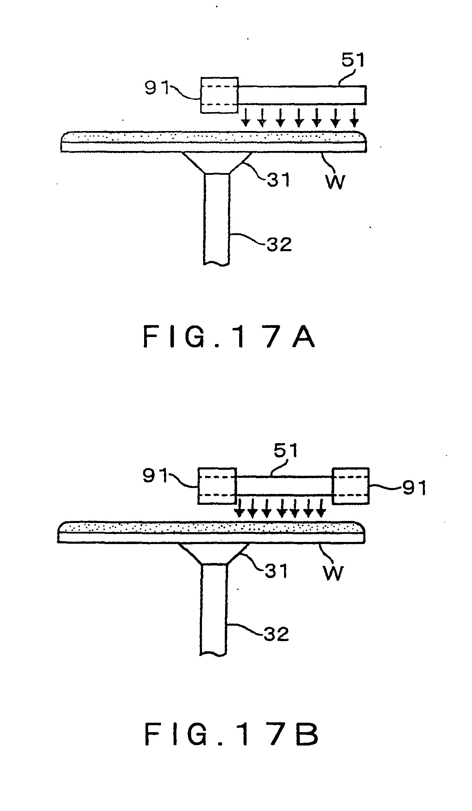

Following thereto, as Comparative Example 4-1, a resist film was deposited on a wafer W by using the coating apparatus 2, similarly to Example 4-1. However, as shown in Fig. 17A, an end of the gas nozzle 51, which is positioned above the central portion of the wafer W when the gas nozzle 51 ejected an He gas, was covered with the cover 91, such that no He gas was ejected toward the central portion.

In addition, as Example 4-2, as shown in Fig. 17B, opposed ends of the gas nozzle 51 were covered with the covers 91, such that no He gas was ejected toward the central portion and the peripheral portion of the wafer W.

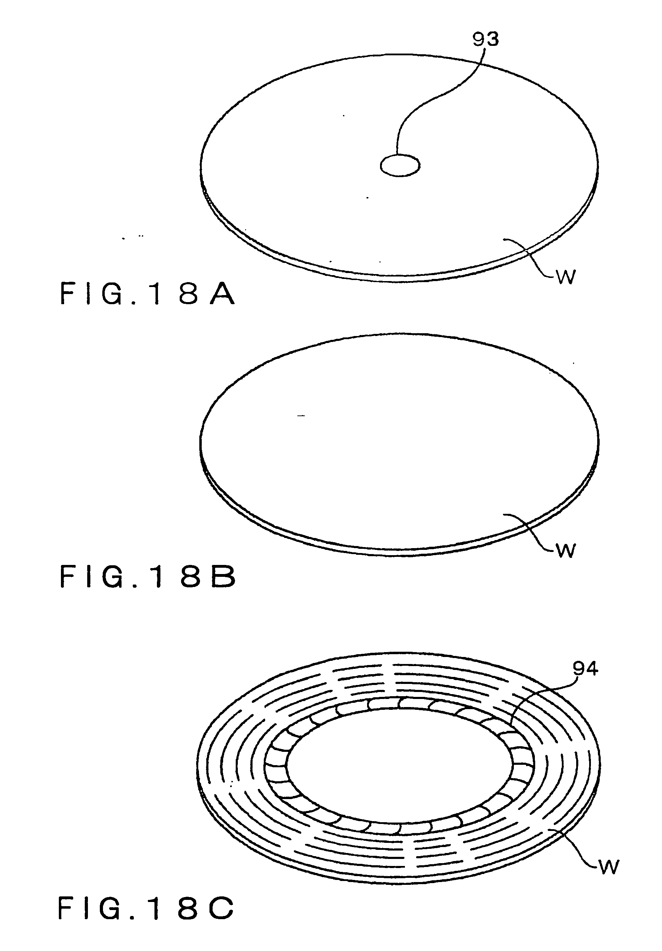

Figs. 18A to 18C are views showing the wafers W that were subjected to the film-deposition process in Examples 4-1 to 4-4 and Comparative Examples 4-1 and 4-2.

In Examples 4-1 to 4-3, as shown in Fig. 18A, an ejection trajectory of the He gas 93 was formed on the central portion of each of the wafers W, but no windmill-like track was formed on the peripheral portion of each of the wafers W.

In Example 4-4, as shown in Fig. 18B, neither windmill-like track nor ejection trajectory of the He gas 93 was observed.

As to the wafers W of Comparative Examples 4-1 and 4-2, as shown in Fig. 18C, windmill-like tracks 94 were formed on an inside area of the wafer W. In addition, another part that is outside the part on which the windmill-like tracks 94 were formed was exposed to a turbulent flow, and a large number of lines generated by transfer of the flow of the turbulent flow were observed.

Thus, it was confirmed that, from Examples 4-1 to 4-4 and Comparative Examples 4-1 and 4-2, by supplying an He gas to the area including the central portion, the coefficient of kinematic viscosity of the gas in the vicinity of the surface of the wafer W was raised and the area in which the laminar flow was formed was enlarged, so that formation of windmill-like tracks could be prevented, while the area in which the resist film of a uniform thickness was formed could be widened.

Further, as apparent from Examples 4-1 to 4-4, the ejection trajectory of the He gas 93 in Examples 4-1 to 4-3 can be improved by adjusting the distance between the gas nozzle 51 and the wafer W. The ejection trajectory 93 was formed because a large amount of the He gas was supplied to the central portion to apply a pressure thereto. Thus, it is considered that the ejection trajectory 93 can be improved by adjusting the flow rate of the He gas.

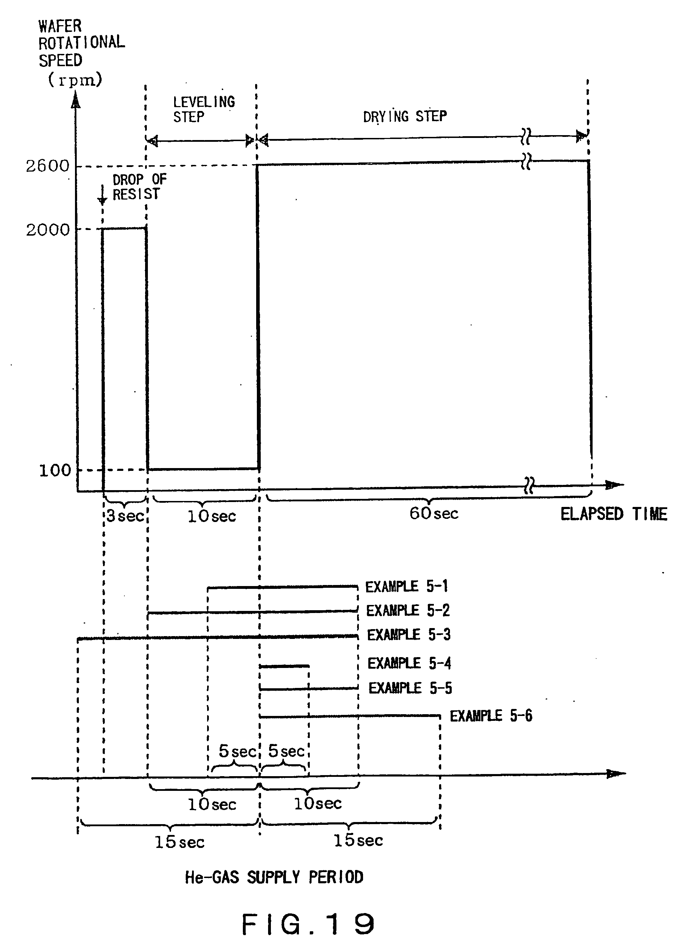

Further, resist films were deposited on wafers W with the use of the coating apparatus 2, with the timing of starting supply of an He gas and the timing of stopping the supply of the He gas being changed. Fig. 19 is a graph showing the timings of ejection and stop of an He gas, the timing of dropping a resist on a wafer W, the timing of starting the leveling of the resist, and the timing of starting the drying of the resist. In this graph, the axis of abscissa shows a time period, and the axis of ordinate shows a rotational speed of the wafer W.

As shown in the graph, the resist was dropped on the wafer W that was being rotated at the rotational speed of 2000 rpm. After 3 seconds had passed from the dropping of the resist, the rotational speed of the wafer W was decreased to 100 rpm so as to perform the leveling of the resist for 10 seconds. Thereafter, the rotational speed of the wafer W was increased to 2600 rpm so as to perform the drying of the resist for 60 seconds. Similarly to the above embodiment, by using the gas nozzle 51 as a gas nozzle, an He gas was radially ejected from the central portion of the wafer W to the peripheral portion thereof. The flow rate of the He gas at the drying step was 40 L/min. The distance between the lower end of the gas nozzle 51 and the wafer W, which is indicated by h in Fig. 1, was 2 mm.

Under the conditions as described above, as Example 5-1, the ejection of the He gas was started 5 seconds after the start of the leveling, and the ejection of the gas was stopped 10 seconds after the start of the drying step. As Example 5-2, the He gas was ejected simultaneously with the start of the leveling step, and the supply of the He gas was stopped 10 seconds after the start of the drying step. As Example 5-3, the He gas was ejected 5 seconds before the start of the leveling step, and the supply of the He gas was stopped 10 seconds after the start of the drying step. As Example 5-4, the He gas was ejected simultaneously with the start of the drying step, and the supply of the He gas was stopped 5 seconds after the start of the ejection thereof. As Example 5-5, the He gas was ejected simultaneously with the start of the drying step, and the supply of the He gas was stopped 10 seconds after the start of the ejection thereof. As Example 5-6, the He gas was ejected simultaneously with the start of the drying step, and the supply of the He gas was stopped 15 seconds after the start of the ejection thereof.

The results were as follows. In Examples 5-1 to 5-3 and Examples 5-5 and 5-6, as shown in Fig. 18A, an ejection trajectory 93 was formed on the peripheral portion of the wafer W. On the other hand, in Example 5-4, as shown in Fig. 18C, windmill-like tracks were formed on an inside area of the wafer W. As has been described, it is preferable to supply an He gas at the drying step, in order to improve uniformity of the resist film. From Examples 5-1 to 5-6, it was found that the effect of the present invention could be obtained even when an He gas was supplied only at the drying step, as long as the He gas was supplied for a sufficient time period. In Example 5-4, it is considered that, since the supply period of the He gas was so short and the supply of the gas was not continued until the resist film was cured, the windmill-like tracks were formed.

Next, in the coating apparatus 2, resist films were deposited on wafers W in accordance with the procedure as described above, with the height of the gas nozzle 51 (height indicated by h in Fig. 1), the flow rate of the He gas ejected from the gas nozzle 51, and the rotational speed of the wafer W at the drying step being changed. As Example 6-1, h was set at 5 mm, and the He-gas flow rate was set at 20 L/min. As Example 6-2, h was set at 5 mm, and the He-gas flow rate was set at 40 L/min. As Example 6-3, h was set at 2 mm, and the He-gas flow rate was set at 20 L/min. As Example 6-4, h was set at 2 mm, and the He-gas flow rate was set at 40 L/min. At the drying step of each of Examples 6-1 to 6-4, the film-deposition process was performed to each wafer while changing the rotational speed of the wafers W at every 100 rpm increment in a range between 1600 rpm and 3000 rpm. As Comparative Example 6-1, a film-deposition process was performed in the same manner as Example 6-1, excluding that an $N_2$ gas in place of an He gas was ejected from the gas nozzle 51 to the wafer W at a flow rate of 40 L/min. The distance h between the gas nozzle 51 and the wafer W was set at 5 mm.

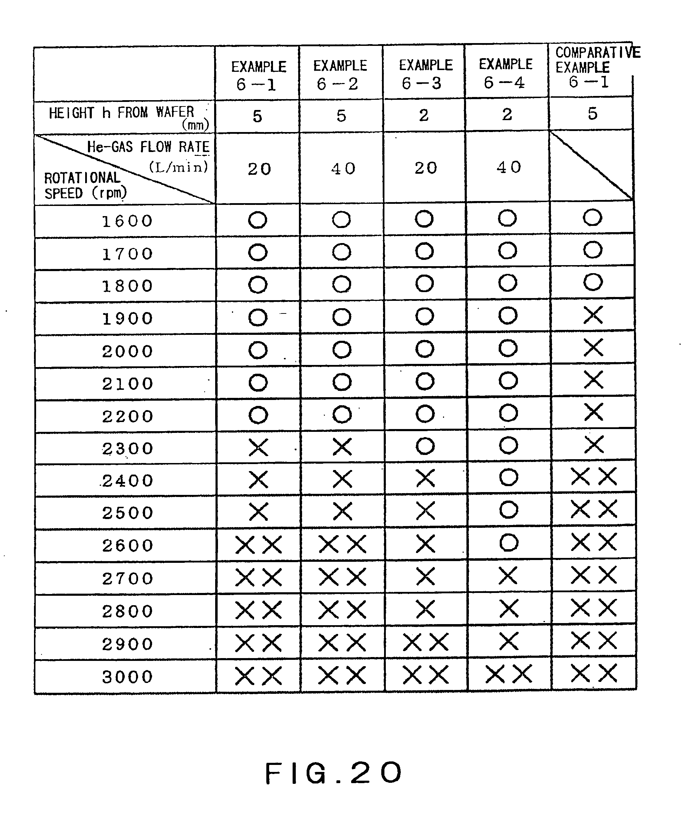

The table of Fig. 20 shows the results of Examples 6-1 to 6-4 and the result of Comparative Example 6-1. The mark ○ represents that no windmill-like track was formed on the wafer W. The mark × represents that windmill-like tracks were formed. The mark × × represents that there were formed windmill-like tracks and lines on the outside of the windmill-like tracks, which were formed by exposure to a turbulent flow. As shown in the table, the formation of windmill-like tracks could be restrained and satisfactory films could be deposited, when the rotational speed of the wafer W was not more than 2200 rpm in Example 6-1, not more than 2200 rpm in Example 6-2, not more than 2300 rpm in Example 6-3, and not more than 2600 rpm in Example 6-4. In addition, it can be understood that the formation of a turbulent flow could be restrained on the wafer W, when the rotational speed of the wafer W was not more than 2500 rpm in Example 6-1, not more than 2500 rpm in Example 6-2, not more than 2800 rpm in Example 6-3, and not more than 2900 rpm in Example 6-4. On the other hand, in Comparative Example 6-1, it can be understood that the formation of windmill-like tracks could be restrained only at the rotational speed not more than 1800 rpm, and that a turbulent flow was generated at the rotational speed not less than 2400 rpm. From the above results, it can be understood that, by supplying an He gas to the wafer W, an area on which a laminar flow is formed can be enlarged, and generation of a transition flow and a turbulent flow can be restrained on the surface of the wafer W.

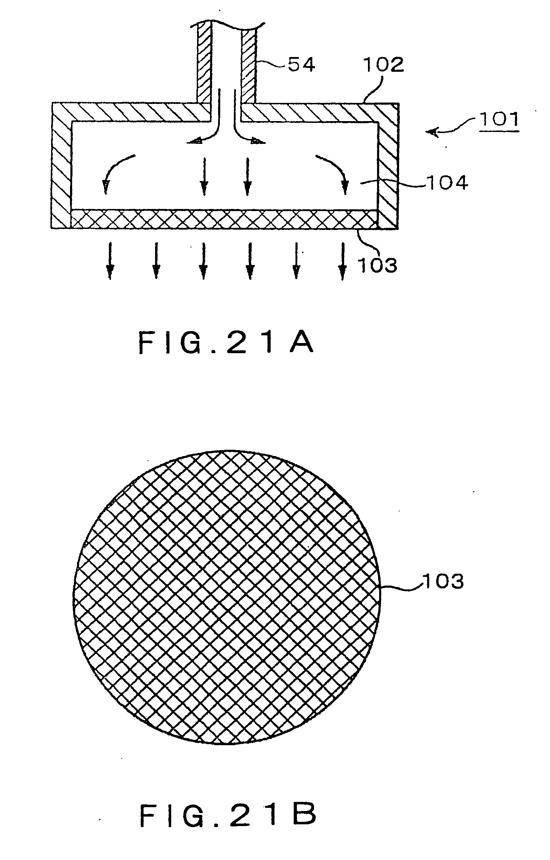

Following thereto, in order to confirm the effect of the present invention, films were deposited in Comparative Example 7-1 and Examples 7-1 to 7-3. Fig. 21A shows a structure of a gas nozzle 101 used in Comparative Example 7-1 and Examples 7-1 to 7-3. The reference number 102 depicts a gas supply head that is formed into a flat cylindrical shape with a lower surface thereof being opened. A gas supply plate 103 made of, e.g., porous ceramics, is disposed to block the opening of the gas supply head 102. As shown in Fig. 21B, the gas supply plate 103 has a circular shape and has a diameter of 50 mm. The reference number 104 depicts a ventilation chamber that is surrounded by the gas supply head 102 and the gas supply plate 103. The ventilation chamber 104 is communicated with the gas supply pipe 54 connected to an upper center of the gas supply head 102. An He gas, which has been supplied from the gas supply pipe 54 to the ventilation chamber 104, passes through holes formed in the gas supply plate 103 so as to be ejected from the overall lower surface of the gas supply plate 103 in a shower-like manner, as shown by the arrows in Fig. 21A.

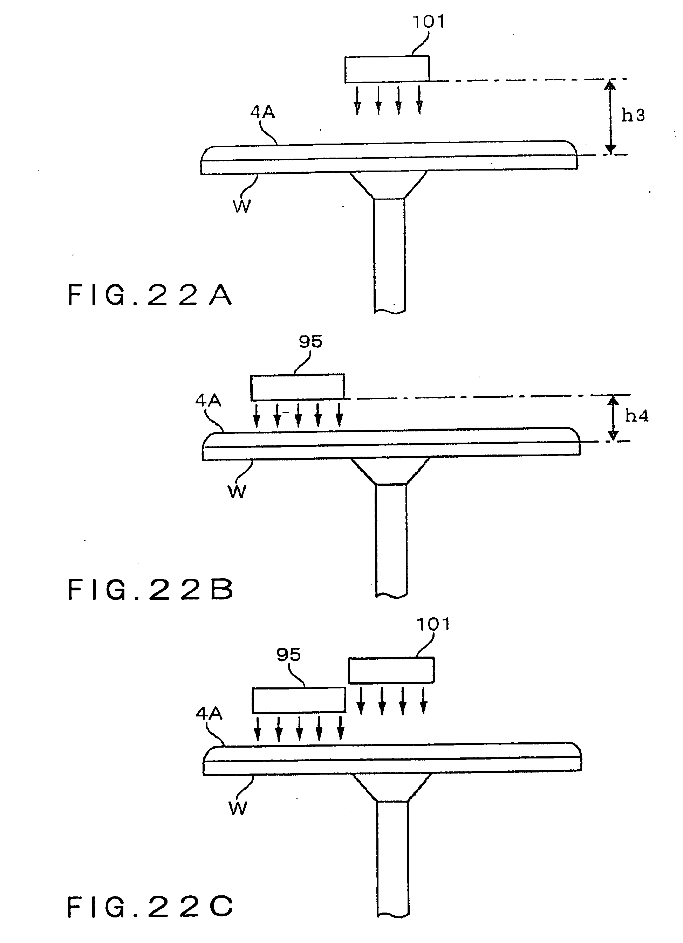

Next, as Comparative Example 7-1, as shown in Fig. 22A, with the use of the gas nozzle 101 in place of the gas nozzle 51, resist films were deposited, while an He gas was being supplied, on wafers W, with the rotational speed at the step of drying the resist being changed, in accordance with the procedure similar to those of Examples 6-1 to 6-4. However, in Comparative Example 7-1, when an He gas was supplied to the wafer W, the gas nozzle 101 was disposed at a height location such that a distance, which is indicated by h3 in Fig. 22A, between the lower end of the gas nozzle 101 and the surface of the wafer W was 25 mm. At this height position, the gas supply plate 103 of the gas nozzle 101 was in parallel with the wafer W and covered the central portion of the wafer W. The flow rate of the He gas was set at 10 L/min.

Subsequently, as Example 7-1, films were deposited on wafers W at various rotational speeds in accordance with the same procedure and under the same process conditions as those of Comparative Example 7-1, excluding that the flow rate of the He gas was set at 30 L/min.

In addition, as Example 7-2, as shown in Fig. 22B, the gas nozzle 95 in place of the gas nozzle 101 was used, and while an He gas was being supplied from the gas nozzle 95, resist films were deposited on wafers W at various rotational speeds at the step of drying the resist, similarly to Example 7-1. This gas nozzle 95 was structured substantially similarly to the gas nozzle 51 used in Examples 6-1 to 6-4, but a length of the gas nozzle 95 was shorter than the length of the gas nozzle 51, i.e., the length of the gas nozzle 95 was 100 mm. When the gas nozzle 95 supplied an He gas, the gas nozzle 95 was disposed along the radial direction of the wafer W. However, as shown in Fig. 22B, the gas nozzle 95 did not cover the central portion and the peripheral portion of the wafer W, and an air flowing downward was supplied to the central portion of the wafer W. A height between the surface of the wafer W and the lower end of the gas nozzle 95 when the gas nozzle 95 supplied an He gas, which is indicated by h4 in Fig. 22B, was set at 2 mm. The flow rate of the He gas was set at 30 L/min.

Further, as Example 7-3, as shown in Fig. 22C, while an He gas was being supplied from the gas nozzle 101 and the gas nozzle 95, resist films were deposited on wafers W, with the rotational speed at the step of drying the resist being changed. In Example 7-3, the position of the gas nozzle 101 and the position of the gas nozzle 95 when the gas nozzles 101 and 95 supplied an He gas to the wafer W, were set the same as in Example 7-1 and Example 7-2, respectively. The flow rate of the He gas from the gas nozzle 101 and the flow rate of the He gas from the gas nozzle 95 were set at 10 L/min and 30 L/min, respectively.

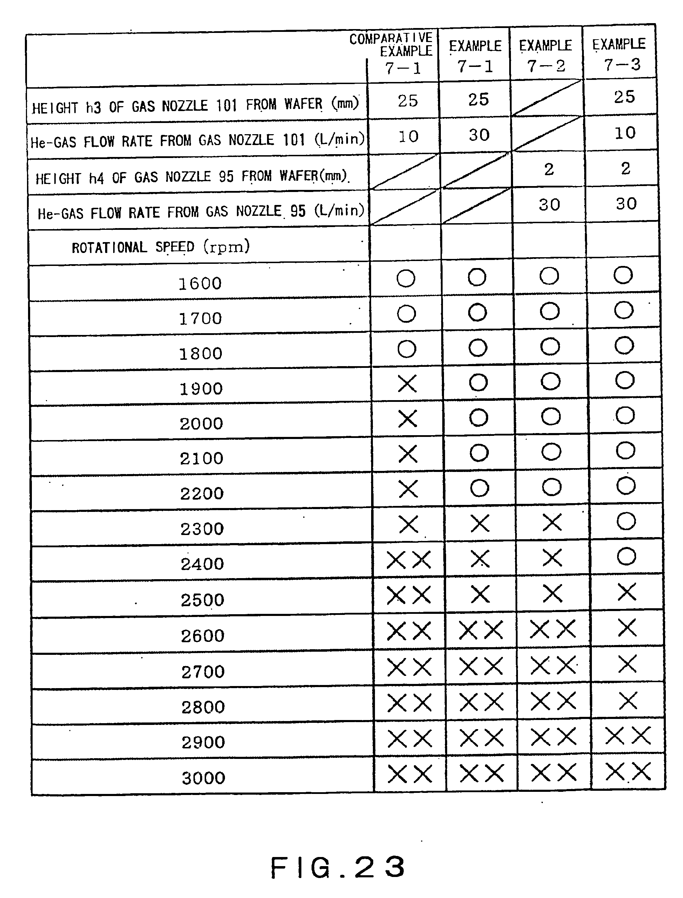

The results of Comparative Example 7-1 and Examples 7-1 to 7-3 are shown in the table of Fig. 23. The meanings of the marks ○, ×, and × × in the table are the same as those of the marks used in Fig. 20. As shown in the table of Fig. 23, the formation of windmill-like tracks could be restrained and satisfactory films could be deposited, when the rotational speed of the wafer W was not more than 2200 rpm in Example 7-1, not more than 2200 rpm in Example 7-2, and not more than 2400 rpm in Example 7-3. Since the data of Comparative Example 7-1 were the same as those of Comparative Example 6-1, it can be understood that the supply of the He gas produces substantially no effect, in the case in which h3 is 25 mm and the He flow rate is 10 L/min.

From the result of Example 7-2, it can be understood that, even when the He gas is not supplied to the central portion of the wafer W as in the aforementioned Examples 6-1 to 6-4, the He gas can restrain the generation of windmill-like tracks. That is to say, under a state in which a laminar flow is formed in a space above the center of the wafer W and the surface of the wafer is filled with an atmospheric gas (e.g., air) without the He gas, it is considered that the generation of windmill-like tracks can be restrained by supplying the He gas from a position more upstream (closer to the center of the wafer) than a position where a transition flow is generated.

In the surfaces of the wafers W in the aforementioned Comparative Example 4-1 and Comparative Example 4-2, as shown in Fig. 18C, the windmill-like tracks were formed, and thus the film-thickness of the resist was non-uniform. The reason therefor is considered that, since the air flowing downward from the filter 61 was also blocked by the cover 91, a laminar flow was not supplied to a space above the center of the wafer W.

In addition, as in Example 7-3, when the He gas is supplied from the gas nozzle 95 and the nozzle 101 to the different positions of the wafer W, i.e., to the central portion and the area outside the central portion in this example, parameters, such as the distances from the gas nozzle 95 and the nozzle 101 for supplying the He gas to the wafer W, and the flow rates of the gas supplied from the respective nozzles, can be independently adjusted. Thus, uniformity of the film-thickness of the resist can be more improved. Accordingly, there can be restrained formation of the ejection trajectory of the He gas 93 on the central portion of the wafer W, which was seen in Examples 4-1 to 4-3. As clearly understood from Example 7-2, an air in place of the He gas may be ejected from the gas nozzle 101.

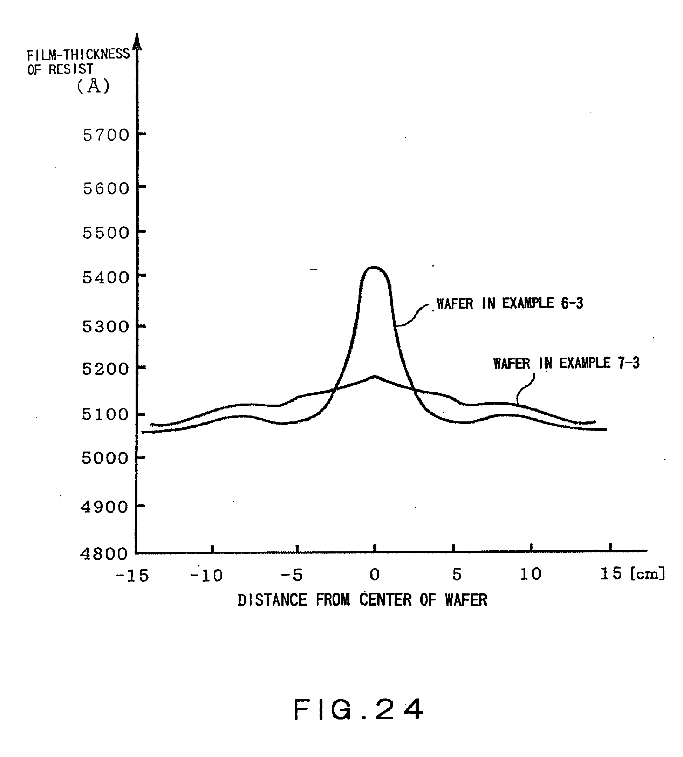

Next, the wafers W processed in Example 6-3 and Example 7-3 at the same rotational speed (2200 rpm) were selected, and the film thicknesses of the resist on the wafers W were measured. Fig. 24 is a graph showing a relationship between a position from the center of each wafer W and a film-thickness of the resist at this position.

As shown in the graph, the wafer W processed in Example 7-3 has an improved uniformity in the thickness of the resist film.

The flow rates of the He gas shown in the above-described Examples and Comparative Examples were measured by a simple (portable) flowmeter for measuring flow rates of an air and an $N_2$ gas. Thus, the actual flow rates of the He gas are considered to be about 1.4 times larger than the flow rates as has been shown.

**Claims**

1. A coating apparatus (2) comprising:

   a substrate-holding part (31) that is arranged to hold a substrate (W) horizontally;
   a chemical nozzle (41) that is arranged to supply a chemical (4A) to a central portion of the substrate (W) horizontally held by the substrate-holding part (31);
   a rotation mechanism (33) that is arranged to cause the substrate-holding part (31) to rotate in order to spread out the chemical (4A) on a surface of the substrate (W) by a centrifugal force, for coating the whole surface (W) with the chemical (4A);
   a gas-flow-forming unit (61, 63, 64) that is arranged to form a down flow of an atmospheric gas on the surface of the substrate (W) horizontally held by the substrate-holding part (31) ;
   a gas-discharging unit (30) that is arranged to discharge an atmosphere around the substrate (W); wherein the apparatus is arranged to supply the atmospheric gas or the laminar-flow-forming gas to the central portion of the substrate (W),
   **characterized in** comprising
   a gas nozzle (51, 7, 74, 76, 8, 83, 85, 92, 101, 95) that is arranged to supply a laminar-flow-forming gas to the surface of the substrate (W), the laminar-flow-forming gas having a coefficient of kinematic viscosity larger than that of the atmospheric gas.

2. A coating apparatus (2) according to claim 1, wherein the gas nozzle (51, 7, 74, 76, 8, 83, 85, 92, 95, 101) has a gas ejecting part (66, 73, 75, 81, 84, 86) that opens in a radial direction of the substrate (W) from a position above the central portion of the substrate (W).

3. A coating apparatus (2) according to claim 1, wherein the gas nozzle (51, 7, 74, 76, 8, 83, 85, 92, 95, 101) has a gas ejecting part (66, 73, 75, 81, 84, 86) consisting of a large number of holes arranged in a radial direction of the substrate from a position above the central portion of the substrate (W).

4. A coating apparatus (2) according to any of claims 1 to 3,
   wherein
   the gas nozzle (51, 101) has a porous body (501, 103).

5. A coating apparatus (2) according to any of claims 1 to 4, wherein
   a flow rate ejected from the gas nozzle (8, 83, 85) is larger at an area closer to a peripheral edge of the substrate (W).

6. A coating apparatus (2) according to any of claims 1 to 5, wherein
   the gas nozzle (51, 7, 74, 76, 8, 83, 85, 92) is configured to supply the laminar-flow-forming gas both to the central portion of the substrate (W) and to an area of the substrate (W) apart from the central portion thereof.

7. A coating apparatus (2) according to any of claims 1 to 5, wherein
   the gas nozzle (95) is configured to supply the laminar-flow-forming gas to an area of the substrate (W) apart from the central portion thereof, and
   the central portion of the substrate (W) is adapted to be exposed to the down flow of the atmospheric gas.

8. A coating apparatus (2) according to any of claims 1 to 5, wherein
   a second gas nozzle (101) is provided independently from the gas nozzle (51, 7, 74, 76, 8, 83, 85, 92, 95), the second gas nozzle (101) being configured to supply a laminar-flow-forming gas or the atmospheric gas to the central portion of the substrate (W).

9. A coating method of coating a substrate (W) with a chemical (4A), the coating method comprising:

   a step of causing a substrate-holding part (31) to hold a substrate (W) horizontally;
   a step of discharging an atmosphere around the substrate (W) while forming a down flow of an atmospheric gas on a surface of the substrate (W) held by the substrate-holding part (31);
   a coating step, by supplying a chemical (4A) from a chemical nozzle (41) to a central portion of the substrate (W), causing the substrate-holding part (31) to rotate, and thus spreading out the chemical (4A) on the surface of the substrate (W) by a centrifugal force for coating the whole surface (W) with the chemical (4A); and
   a drying step, by supplying a laminar-flow-forming gas from a gas nozzle (51, 7, 74, 76, 8, 83, 85, 92, 95, 101) to the surface of the substrate (W) under a state wherein the substrate (W) is caused to rotate, and supplying the atmospheric gas or the laminar-flow-forming gas to the central portion of the substrate (W), so as to dry the chemical (4A), after the coating step, the laminar-flow-forming gas having a coefficient of kinematic viscosity larger than that of the atmospheric gas.

10. A coating method according to claim 9, wherein a timing at which the laminar-flow-forming gas is supplied to the surface of the substrate (W) and the atmospheric gas or the laminar-flow-forming gas are supplied to the central portion of the substrate (W) is the same as or prior to a timing at which the substrate (W) starts to rotate with a rotation number suitable for drying the chemical (4A).

11. A coating method according to claim 9 or 10, wherein the gas nozzle (51, 7, 74, 76, 8, 83, 85, 92, 95, 101) has a gas ejecting part (66, 73, 75, 81, 84, 86) that opens in a radial direction of the substrate (W) from a position above the central portion of the substrate (W).

12. A coating method according to claim 9 or 10, wherein the gas nozzle (51, 7, 74, 76, 8, 83, 85, 92, 95, 101) has a gas ejecting part consisting of a large number of holes arranged in a radial direction of the substrate (W) from a position above the central portion of the substrate (W).

13. A coating method according to any of claims 9 to 12, wherein
    the gas nozzle (51, 101) has a porous body (501, 103).

14. A coating method according to any of claims 9 to 13, wherein
    a flow rate ejected from the gas nozzle (8, 83, 85) is larger at an area closer to a peripheral edge of the substrate (W).

**Patentansprüche**

1. Beschichtungsvorrichtung (2) mit:

   einem Substrathalteteil (31), das so angeordnet ist, dass es ein Substrat (W) horizontal hält;
   einer chemischen Düse (41), die so angeordnet ist, dass sie eine Chemikalie (4A) einem zentralen Abschnitt des Substrates (W), welches horizontal durch das Substrathalteteil (31) gehalten wird, zuführt;
   einem Rotationsmechanismus (33), der so angeordnet ist, dass er das Substrathalteteil (31) veranlasst zu rotierten, um durch Zentrifugalkräfte die Chemikalie (4A) auf der Oberfläche des Substrates (W) zu verteilen, um die gesamte Oberfläche (W) mit der Chemikalie (4A) zu beschichten;

einer Gasflussformierungseinheit (61, 63, 64), die so angeordnet ist, dass sie einen Fluss nach unten eines atmosphärischen Gases auf der Oberfläche des Substrates (W), welches horizontal durch das Substrathalteteil (31) gehalten wird, bildet;

einer Gasfreisetzungseinheit (30), die so angeordnet ist, dass sie eine das Substrat (W) umgebende Atmosphäre freisetzt, bei der die Vorrichtung so angeordnet ist, dass das atmosphärische Gas oder das die laminare Strömung formende Gas dem zentralen Abschnitt des Substrates (W) zugeführt wird,

**gekennzeichnet durch**

eine Gasdüse (51, 7, 74, 76, 8, 83, 85, 92, 101, 95) die so angeordnet ist, dass sie der Substratoberfläche (W) ein eine laminare Strömung formendes Gas zuführt, das einen kinematischen Viskositätskoeffizienten größer als der des atmosphärischen Gases aufweist.

2. Beschichtungsvorrichtung (2) gemäß Anspruch 1, bei dem

die Gasdüse (51, 7, 74, 76, 8, 83, 85, 92, 95, 101) ein Gasaustrittsteil (66, 73, 75, 81, 84, 86) aufweist, das sich in radialer Richtung des Substrates (W) von einer Position oberhalb des zentralen Abschnittes des Substrates (W) her öffnet.

3. Beschichtungsvorrichtung (2) gemäß Anspruch 1, bei dem

die Gasdüse (51, 7, 74, 76, 8, 83, 85, 92, 95, 101) ein Gasaustrittsteil (66, 73, 75, 81, 84, 86) aufweist, das aus einer großen Anzahl von Öffnungen besteht, die in radialer Richtung des Substrates von einer Position oberhalb des zentralen Abschnittes des Substrates (W) her angeordnet sind.

4. Beschichtungsvorrichtung (2) gemäß einem der Ansprüche 1 bis 3, bei dem

die Gasdüse (51, 101) einen porösen Körper (501, 103) aufweist.

5. Beschichtungsvorrichtung (2) gemäß einem der Ansprüche 1 bis 4, bei der

eine aus der Gasdüse (8, 83, 85) ausgestoßene Flussrate in Abschnitten näher an den Umfangsrändern des Substrates (W) größer ist.

6. Beschichtungsvorrichtung (2) gemäß einem der Ansprüche 1 bis 5, bei der

die Gasdüse (51, 7, 74, 76, 8, 83, 85, 92) so ausgeführt ist, dass sie das eine laminare Strömung formende Gas zu sowohl dem zentralen Abschnitt des Substrates (W) als auch den anderen Abschnitten des Substrates (W) zuführt.

7. Beschichtungsvorrichtung (2) gemäß einem der Ansprüche 1 bis 5, bei der

die Gasdüse (95) so ausgeführt ist, dass sie das eine laminare Strömung formende Gas zu Abschnitten des Substrates (W) ausgenommen des zentralen Abschnitts desselben zuführt, und

der zentrale Abschnitt des Substrates (W) dafür angepasst ist, dem Fluss nach unten des atmosphärischen Gas ausgesetzt zu sein.

8. Beschichtungsvorrichtung (2) gemäß einem der Ansprüche 1 bis 5, bei der

eine zweite Gasdüse (101) unabhängig von der Gasdüse (51, 7, 74, 76, 8, 83, 85, 92, 95) bereitgestellt wird, wobei die zweite Gasdüse (101) so ausgeführt ist, dass sie dem zentralen Abschnitt des Substrates (W) ein eine laminare Strömung formendes Gas oder das atmosphärische Gas zuführt.

9. Beschichtungsverfahren zur Beschichtung eines Substrates (W) mit einer Chemikalie (4A), das aufweist:

einen Schritt zum Veranlassen, dass das Substrat (W) durch ein Substrathalteteil (31) horizontal gehalten wird;

einen Schritt zur Freisetzung einer Atmosphäre um das Substrat (W) herum, während der Bildung eines Flusses eines atmosphärischen Gases nach unten auf eine Oberfläche des Substrates (W) das durch das Substrathalteteil (31) gehalten wird;

einen Beschichtungsschritt, indem eine Chemikalie (4A) aus einer chemischen Düse (41) einem zentralen Abschnitt des Substrates (W) zugeführt wird, das Substrathalteteils (31) veranlasst wird zu rotieren, die Chemikalie (4A) somit auf der Substratoberfläche (W) durch eine Zentrifugalkraft ausgebreitet wird, um die gesamten Oberfläche (W) mit der Chemikalie (4A) zu beschichten; und

einen Trocknungsschritt, durch die Zuführung eines eine laminare Strömung formenden Gases aus einer Gasdüse (51, 7, 74, 76, 8, 83, 85, 92, 95, 101) auf die rotierende Substratoberfläche (W) und durch Zuführung des atmosphärischen Gases oder des eine laminare Strömung formende Gases zu dem zentralen Abschnitt des Substrates (W), um die Chemikalie (4A) nach dem Beschichtungsschritt zu trocknen, wobei das eine laminare Strömung formende Gas einen kinematischen Viskositätskoeffizienten größer als der des atmosphärischen Gases aufweist.

10. Beschichtungsverfahren gemäß Anspruch 9, bei dem der Zeitpunkt, an dem das die laminare Strömung formende Gas der Substratoberfläche (W) zugeführt wird, sowie der Zeitpunkt, bei dem das atmosphärische Gas oder das die laminare Strömung formende Gas den zentralen Abschnitten des Substrates (W) zugeführt wird, der Gleiche ist oder vor dem liegt, an dem das Substrat (W) mit einer für das Trocknen der Chemikalie (4A) geeigneten Umdrehungszahl zu drehen beginnt.

11. Beschichtungsverfahren gemäß Anspruch 9 oder 10, bei dem
die Gasdüse (51, 7, 74, 76, 8, 83, 85, 92, 95, 101) ein Gasaustrittsteil (66, 73, 75, 81, 84, 86) hat, das sich in radialer Richtung des Substrates (W) von einer Position oberhalb des zentralen Abschnittes des Substrates (W) hin öffnet.

12. Beschichtungsverfahren gemäß Anspruch 9 oder 10, bei dem die Gasdüse (51, 7, 74, 76, 8, 83, 85, 92, 95, 101) ein Gasaustrittsteil hat, welches aus einer großen Anzahl von Öffnungen besteht, die in einer radialen Richtung des Substrates (W) von einer Position oberhalb des zentralen Abschnittes des Substrates (W) her angeordnet sind.

13. Beschichtungsverfahren gemäß einem der Ansprüche 9 bis 12, bei dem
die Gasdüse (51, 101) einen porösen Körper (501, 103) aufweist.

14. Beschichtungsverfahren gemäß einem der Ansprüche 9 bis 13, bei dem
eine aus der Gasdüse (8, 83, 85) ausgestoßene Flussrate in Abschnitten näher an den Umfangsrändern des Substrates (W) größer ist.

**Revendications**

1. Appareil de revêtement (2) comprenant :

une partie maintien de substrat (31) qui est agencée de façon à maintenir un substrat (W) de manière horizontale ;
une buse de produit chimique (41) qui est agencée de façon à fournir un produit chimique (4A) à une partie centrale du substrat (W) maintenu de manière horizontale par la partie maintien de substrat (31) ;
un mécanisme de rotation (33) qui est agencé de façon à faire tourner la partie maintien de substrat (31) de manière à étaler le produit chimique (4A) sur une surface du substrat (W) sous l'action d'une force centrifuge, de façon à revêtir toute la surface (W) avec le produit chimique (4A) ;
une unité de formation d'écoulement de gaz (61, 63, 64) qui est agencée de façon à former un écoulement de gaz atmosphérique vers le bas sur la surface du substrat (W) maintenu de manière horizontale par la partie maintien de substrat (31) ;
une unité d'évacuation de gaz (30) qui est agencée de façon à évacuer l'atmosphère autour du substrat (W) ;
dans lequel l'appareil est agencé de façon à fournir le gaz atmosphérique ou le gaz de formation d'écoulement laminaire à la partie centrale du substrat (W) ;
**caractérisé en ce qu'**il comprend :

une buse de gaz (51, 7, 74, 76, 8, 83, 85, 92, 101, 95) qui est agencée de façon à fournir un gaz de formation d'écoulement laminaire à la surface du substrat (W), le gaz de formation d'écoulement laminaire présentant un coefficient de viscosité cinématique plus grand que celui du gaz atmosphérique.

2. Appareil de revêtement (2) selon la revendication 1, dans lequel :

la buse de gaz (51, 7, 74, 76, 8, 83, 85, 92, 95, 101) présente une partie éjection de gaz (66, 73, 75, 81, 84, 86) qui s'ouvre dans une direction radiale du substrat (W) à partir d'une position qui se situe au-dessus de la partie centrale du substrat (W).

3. Appareil de revêtement (2) selon la revendication 1, dans lequel :

la buse de gaz (51, 7, 74, 76, 8, 83, 85, 92, 95, 101) présente une partie éjection de gaz (66, 73, 75, 81, 84, 86) qui consiste en un grand nombre de trous agencés dans une direction radiale du substrat à partir d'une position qui se situe au-dessus de la partie centrale du substrat (W).

4. Appareil de revêtement (2) selon l'une quelconque des revendications 1 à 3, dans lequel :

la buse de gaz (51, 101) présente un corps poreux (501, 103).

5. Appareil de revêtement (2) selon l'une quelconque des revendications 1 à 4, dans lequel :

le débit d'écoulement éjecté par la buse de gaz (8, 83, 85) est plus grand au niveau d'une zone plus proche d'un bord périphérique du substrat (W).

6. Appareil de revêtement (2) selon l'une quelconque des revendications 1 à 5, dans lequel :

la buse de gaz (51, 7, 74, 76, 8, 83, 85, 92) est configurée de façon à fournir le gaz de formation d'écoulement laminaire à la partie centrale du substrat (W) et à une zone du substrat (W) en plus de la partie centrale de celui-ci.

**7.** Appareil de revêtement (2) selon l'une quelconque des revendications 1 à 5, dans lequel :

la buse de gaz (95) est configurée de façon à fournir le gaz de formation d'écoulement laminaire à une zone du substrat (W) en plus de la partie centrale de celui-ci ; et
la partie centrale du substrat (W) est adaptée pour être exposée à l'écoulement du gaz atmosphérique vers le bas.

**8.** Appareil de revêtement (2) selon l'une quelconque des revendications 1 à 5, dans lequel :

une seconde buse de gaz (101) est fournie indépendamment de la buse de gaz (51, 7, 74, 76, 8, 83, 85, 92, 95), la seconde buse de gaz (101) étant configurée de façon à fournir un gaz de formation d'écoulement laminaire ou le gaz atmosphérique à la partie centrale du substrat (W).

**9.** Procédé de revêtement d'un substrat (W) avec un produit chimique (4A), le procédé de revêtement comprenant :

une étape consistant à faire maintenir de manière horizontale un substrat (W) par une partie maintien de substrat (31) ;
une étape consistant à évacuer l'atmosphère autour du substrat (W) tout en formant un écoulement vers le bas d'un gaz atmosphérique sur une surface du substrat (W) maintenu par la partie maintien de substrat (31) ;
une étape de revêtement, en fournissant un produit chimique (4A) à partir d'une buse de produit chimique (41) à une partie centrale du substrat (W), en faisant tourner la partie maintien de substrat (31), et en étalant de ce fait le produit chimique (4A) sur la surface du substrat (W) par l'action d'une force centrifuge de façon à revêtir toute la surface (W) avec le produit chimique (4A) ; et
une étape de séchage, en fournissant un gaz de formation d'écoulement laminaire à partir d'une buse de gaz (51, 7, 74, 76, 8, 83, 85, 92, 95, 101) à la surface du substrat (W) dans un état où le substrat (W) est entraîné en rotation, et en fournissant le gaz atmosphérique ou le gaz de formation d'écoulement laminaire à la partie centrale du substrat (W), de façon à sécher le produit chimique (4A) ;
après l'étape de revêtement, le gaz de formation d'écoulement laminaire présentant un coefficient de viscosité cinématique plus grand que celui du gaz atmosphérique.

**10.** Procédé de revêtement selon la revendication 9, dans lequel :

le moment où le gaz de formation d'écoulement laminaire est fourni à la surface du substrat (W) et le moment où gaz atmosphérique ou le gaz de formation d'écoulement laminaire est fourni à la partie centrale du substrat (W), coïncident avec le moment où le substrat (W) commence à tourner, ou interviennent avant celui-ci, avec une vitesse de rotation appropriée au séchage du produit chimique (4A).

**11.** Procédé de revêtement selon la revendication 9 ou la revendication 10, dans lequel :

la buse de gaz (51, 7, 74, 76, 8, 83, 85, 92, 95, 101) présente une partie éjection de gaz (66, 73, 75, 81, 84, 86) qui s'ouvre dans une direction radiale du substrat (W) à partir d'une position qui se situe au-dessus de la partie centrale du substrat (W).

**12.** Procédé de revêtement selon la revendication 9 ou la revendication 10, dans lequel :

la buse de gaz (51, 7, 74, 76, 8, 83, 85, 92, 95, 101) présente une partie éjection de gaz qui consiste en un grand nombre de trous agencés dans une direction radiale du substrat (W) à partir d'une position qui se situe au-dessus de la partie centrale du substrat (W).

**13.** Procédé de revêtement selon l'une quelconque des revendications 9 à 12, dans lequel :

la buse de gaz (51, 101) présente un corps poreux (501, 103).

**14.** Procédé de revêtement selon l'une quelconque des revendications 9 à 13, dans lequel :

le débit d'écoulement éjecté par la buse de gaz (8, 83, 85) est plus grand au niveau d'une zone plus proche d'un bord périphérique du substrat (W).

FIG.1A

FIG.1B

FIG.2

FIG.3A

FIG.3B

FIG.4

FIG.5A

FIG.5B

FIG.5C

FIG.5D

51

4A

W

31

32

# FIG.6A

ROTATIONAL DIRECTION
OF WAFER

W

51

# FIG.6B

## FIG.7A

## FIG.7B

FIG.8A

FIG.8B

71

7

72

FIG.9A

73

72

FIG.9B

FIG. 10A

FIG. 10B

FIG.11A

FIG.11B

FIG.11C

FIG.12A

FIG.12B

54  V3  55  56

W

8

81

72

31

32

# FIG. 13A

8

72

81

W

# FIG. 13B

FIG.14A

FIG.14B

EP 1 975 979 B1

ROTATIONAL DIRECTION
OF WAFER

FIG. 15A

FLOW RATE 27L/min(EXCLUDING FLOW RATES IN PARENTHESES)

| h2[mm] | | JETTING ANGLE $\alpha$ [°] | | | | | |
|---|---|---|---|---|---|---|---|
| | | 20 | 40 | 50 | 60 | 90 | 160 |
| | 1 | | □ | □ (19L/min) | | | |
| | 2.5 | ○ | | | | □ | |
| | 5 | ○ | | | | | |
| | 8 | ▲ | | | □ (30L/min) | | ▲ |
| | 20 | | | | | ○ (60L/min) | |

FIG. 15B

34

FIG.16A

FIG.16B

FIG.16C

FIG.16D

FIG. 1 7 A

FIG. 1 7 B

FIG. 18 A

FIG. 18 B

FIG. 18 C

FIG.19

| | EXAMPLE 6−1 | EXAMPLE 6−2 | EXAMPLE 6−3 | EXAMPLE 6−4 | COMPARATIVE EXAMPLE 6−1 |
|---|---|---|---|---|---|
| HEIGHT h FROM WAFER (mm) | 5 | 5 | 2 | 2 | 5 |
| He-GAS FLOW RATE (L/min) / ROTATIONAL SPEED (rpm) | 20 | 40 | 20 | 40 | |
| 1600 | ◯ | ◯ | ◯ | ◯ | ◯ |
| 1700 | ◯ | ◯ | ◯ | ◯ | ◯ |
| 1800 | ◯ | ◯ | ◯ | ◯ | ◯ |
| 1900 | ◯ | ◯ | ◯ | ◯ | ✕ |
| 2000 | ◯ | ◯ | ◯ | ◯ | ✕ |
| 2100 | ◯ | ◯ | ◯ | ◯ | ✕ |
| 2200 | ◯ | ◯ | ◯ | ◯ | ✕ |
| 2300 | ✕ | ✕ | ◯ | ◯ | ✕ |
| 2400 | ✕ | ✕ | ✕ | ◯ | ✕✕ |
| 2500 | ✕ | ✕ | ✕ | ◯ | ✕✕ |
| 2600 | ✕✕ | ✕✕ | ✕ | ◯ | ✕✕ |
| 2700 | ✕✕ | ✕✕ | ✕ | ✕ | ✕✕ |
| 2800 | ✕✕ | ✕✕ | ✕ | ✕ | ✕✕ |
| 2900 | ✕✕ | ✕✕ | ✕✕ | ✕ | ✕✕ |
| 3000 | ✕✕ | ✕✕ | ✕✕ | ✕✕ | ✕✕ |

FIG.20

EP 1 975 979 B1

FIG.21A

FIG.21B

40

EP 1 975 979 B1

FIG.22A

FIG.22B

FIG.22C

41

| | COMPARATIVE EXAMPLE 7-1 | EXAMPLE 7-1 | EXAMPLE 7-2 | EXAMPLE 7-3 |
|---|---|---|---|---|
| HEIGHT h3 OF GAS NOZZLE 101 FROM WAFER (mm) | 25 | 25 | | 25 |
| He-GAS FLOW RATE FROM GAS NOZZLE 101 (L/min) | 10 | 30 | | 10 |
| HEIGHT h4 OF GAS NOZZLE 95 FROM WAFER(mm) | | | 2 | 2 |
| He-GAS FLOW RATE FROM GAS NOZZLE 95 (L/min) | | | 30 | 30 |
| ROTATIONAL SPEED (rpm) | | | | |
| 1600 | ○ | ○ | ○ | ○ |
| 1700 | ○ | ○ | ○ | ○ |
| 1800 | ○ | ○ | ○ | ○ |
| 1900 | ✕ | ○ | ○ | ○ |
| 2000 | ✕ | ○ | ○ | ○ |
| 2100 | ✕ | ○ | ○ | ○ |
| 2200 | ✕ | ○ | ○ | ○ |
| 2300 | ✕ | ✕ | ✕ | ○ |
| 2400 | ✕✕ | ✕ | ✕ | ○ |
| 2500 | ✕✕ | ✕ | ✕ | ✕ |
| 2600 | ✕✕ | ✕✕ | ✕✕ | ✕ |
| 2700 | ✕✕ | ✕✕ | ✕✕ | ✕ |
| 2800 | ✕✕ | ✕✕ | ✕✕ | ✕ |
| 2900 | ✕✕ | ✕✕ | ✕✕ | ✕✕ |
| 3000 | ✕✕ | ✕✕ | ✕✕ | ✕✕ |

# FIG.23

FIG.24

FIG.25A

FIG.25B

$\nu = \dfrac{\mu}{\rho}$ IS SMALL

← LAMINAR FLOW →

W

# FIG.26A

$\nu = \dfrac{\mu}{\rho}$ IS LARGE

← LAMINAR FLOW →

W

# FIG.26B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5283331 A
- JP 61150126 A
- JP 3245870 A
- US 20020041935 A1

**Non-patent literature cited in the description**

- *J. Appl. Phys.,* 1995, vol. 77 (6), 2297-2308